# EUROPEAN PATENT APPLICATION

(11) **EP 4 488 762 A1**
(43) Date of publication of application: **08.01.2025**
(21) Application number: 23780525.4
(22) Date of filing: 28.03.2023
(51) Int. Cl.: G03F 7/20, G03F 7/24, B29C 59/04

(54) **MANUFACTURING METHOD FOR MASTER DISK, MANUFACTURING METHOD FOR TRANSFERRED OBJECT, MANUFACTURING METHOD FOR REPLICA MASTER DISK, AND MANUFACTURING DEVICE FOR MASTER DISK**

(30) Priority: 31.03.2022 JP 2022058791
(71) Applicant: Dexerials Corporation, Shimotsuke-shi, Tochigi 323-0194 (JP)
(72) Inventor: KIKUCHI, Masanao, Shimotsuke-shi, Tochigi 323-0194 (JP)
(74) Representative: Müller-Boré & Partner Patentanwälte PartG mbB
(86) International application number: PCT/JP2023/012514
(87) International publication number: WO 2023/190516

(57) **Abstract**

A pattern of a concave-convex structure having any three-dimensional shape is formed on an outer circumferential surface of a master with high accuracy. Provided is a method for manufacturing a master, including the steps of forming a resist layer on an outer circumferential surface of a base member, dividing an input image in which an object having a three-dimensional shape is two-dimensionally drawn into a plurality of small regions, determining in a stepwise manner an intensity of laser light to be radiated to each of the small regions based on a contrasting density of a partial image of the object in each of the small regions in which the object is included, and generating an exposure control signal corresponding to the object based on a result of the determining of the intensity of the laser light, radiating the laser light to the resist layer based on the exposure control signal, thereby forming a resist pattern that changes in depth in accordance with the contrasting density of the partial image, and forming a concave-convex pattern corresponding to the three-dimensional shape of the object on the outer circumferential surface of the base member using the resist layer as a mask.

## Description

### Technical Field

The present invention relates to a method for manufacturing a master, a method for manufacturing a transferred object and a replica master through use of a master, as well as an apparatus for manufacturing a master.

### Background Art

In recent years, the development of a nanoimprinting technology of pressing a planar or columnar master having a micro concave-convex pattern formed on its surface against a resin sheet or the like to transfer the micro concave-convex pattern on the master to the resin sheet or the like has been advanced as one of microfabrication technologies. In a case of manufacturing such a master for imprinting, a lithography technology through use of exposure with laser light is used.

For example, Patent Literature 1 discloses a technology for forming a concave-convex structure of microlenses on a surface of a planar die master through lithography with laser light.

In addition, Patent Literature 2 discloses a technology for forming a pattern of a concave-convex structure (for example, a moth-eye structure having a concave-convex period of less than or equal to a wavelength belonging to a visible light band) on an outer circumferential surface of a cylindrical or columnar roll master through thermal lithography with laser light and transferring the pattern of the concave-convex structure on the outer circumferential surface of the roll master to a resin sheet.

### Citation List

### Patent Literature

| | |
|---|---|
| Patent Literature 1: | JP 2018-165811A |
| Patent Literature 2: | JP 2016-028867A |

### Summary of Invention

### Technical Problem

However, in the technology described in Patent Literature 1 above, when a resist film on the surface of the planar die master is exposed with laser light, exposure is performed for each of sectioned exposure target regions. The exposure target regions are sectioned by boundary portions between concavities in which exposure light has a small intensity and an exposure depth is shallow. This raises a problem in that a concave-convex structure having any three-dimensional shape in which concave-convex structures of adjacent sections are coupled continuously and seamlessly cannot be freely formed.

In addition, in the technology described in Patent Literature 2, the intensity of laser light is not modulated when the resist layer on the outer circumferential surface of the roll master is exposed, and the concave-convex pattern is exposed by turning on/off laser light having a constant intensity. Thus, only an exposure pattern having a constant depth can be formed on the resist layer. Therefore, a problem arises in that it is difficult to freely form a concave-convex structure having any three-dimensional shape by arbitrarily varying the depth of the pattern of the concave-convex structure.

The present invention was therefore made in view of the above problems, and an object of the present invention is to form a pattern of a concave-convex structure having any three-dimensional shape on an outer circumferential surface of a master with high accuracy.

### Solution to Problem

In order to solve the above-described problems, according to a certain aspect of the present invention, provided is a method for manufacturing a master, including the steps of forming a resist layer on an outer circumferential surface of a base member having a cylindrical shape or a columnar shape, dividing an input image in which at least one object having a three-dimensional shape is two-dimensionally drawn into a plurality of small regions, determining whether or not to radiate laser light to each of the small regions based on whether or not the object is included in each of the small regions, determining in a stepwise manner an intensity of the laser light to be radiated to each of the small regions based on a contrasting density of a partial image of the object in each of the small regions in which the object is included, and generating an exposure control signal corresponding to the object based on a result of the determining of the intensity of the laser light, radiating, to the resist layer, the laser light modulated in the intensity in accordance with the contrasting density of the partial image of the object for each of the small regions based on the exposure control signal, thereby forming a resist pattern corresponding to the object on the resist layer, and forming a concave-convex pattern corresponding to the three-dimensional shape of the object on the outer circumferential surface of the base member using, as a mask, the resist layer on which the resist pattern has been formed. In the resist pattern, the resist pattern changes in depth in each of the small regions in accordance with the contrasting density of the partial image of the object.

The input image may be a grayscale image that expresses a change in height of the three-dimensional shape of the object using the contrasting density of the grayscale image. In the step of generating the exposure control signal, the intensity of the laser light to be radiated to each of the small regions may be determined in a stepwise manner based on a level of a grayscale of the partial image of the object in each of the small regions in which the object is included.

The exposure control signal may be a modulation signal for modulating in a stepwise manner the intensity of the laser light that exposes the resist layer and may have a step-like waveform in accordance with a level of a grayscale that represents the contrasting density of the partial image of the object.

The small regions may each have a size smaller than a size of a spot of the laser light.

In the step of forming the resist pattern on the resist layer, the laser light may be radiated to the resist layer of the base member while the base member is rotated using a central axis of the base member as a rotation axis.

The exposure control signal may be generated so as to be synchronized with a signal for controlling rotation of the base member.

A light source of the laser light may be a semiconductor laser, the resist layer may be made of an organic resist, and in the step of forming the resist pattern on the resist layer, the resist pattern may be formed on the resist layer through photolithography.

In order to solve the above-described problems, according to another aspect of the present invention, provided is a method for manufacturing a transferred object, including the step of transferring a pattern of the master manufactured by the method for manufacturing the master.

In order to solve the above-described problems, according to another aspect of the present invention, provided is a method for manufacturing a replica master, including the step of transferring a pattern of the transferred object manufactured by the method for manufacturing a transferred object.

In order to solve the above-described problems, according to another aspect of the present invention, provided is a method for manufacturing a transferred object, including the step of transferring a pattern of the replica master manufactured by the manufacturing method according to claim 9.

In order to solve the above-described problems, according to another aspect of the present invention, provided is an apparatus for manufacturing a master, including a deposition device that forms a resist layer on an outer circumferential surface of a base member having a cylindrical shape or a columnar shape, an exposure control device that divides an input image in which at least one object having a three-dimensional shape is two-dimensionally drawn into a plurality of small regions, makes a determination as to whether or not to radiate laser light to each of the small regions based on whether or not the object is included in each of the small regions, makes a determination in a stepwise manner as to an intensity of the laser light to be radiated to each of the small regions based on a contrasting density of a partial image of the object in each of the small regions in which the object is included, and generates an exposure control signal corresponding to the object based on a result of the determination of the intensity of the laser light, an exposure device that radiates, to the resist layer, the laser light modulated in the intensity in accordance with the contrasting density of the partial image of the object for each of the small regions based on the exposure control signal, thereby forming a resist pattern corresponding to the object on the resist layer, and an etching device that forms a concave-convex pattern corresponding to the three-dimensional shape of the object on the outer circumferential surface of the base member using, as a mask, the resist layer on which the resist pattern has been formed. In the resist pattern, the resist pattern changes in depth in each of the small regions in accordance with the contrasting density of the partial image of the object.

### Advantageous Effects of Invention

As described above, according to the present invention, a pattern of a concave-convex structure having any three-dimensional shape can be formed on an outer circumferential surface of a master with high accuracy.

### Brief Description of Drawings

[FIG. 1] FIG. 1 is a perspective view schematically showing a master manufactured by a method for manufacturing the master according to an embodiment of the present invention.
[FIG. 2] FIG. 2 is an explanatory diagram showing a transfer device that manufactures a transferred object using the master according to the embodiment.
[FIG. 3A] FIG. 3A is a cross-sectional view showing each step of the method for manufacturing the master according to the embodiment.
[FIG. 3B] FIG. 3B is a cross-sectional view showing each step of the method for manufacturing the master according to the embodiment.
[FIG. 3C] FIG. 3C is a cross-sectional view showing each step of the method for manufacturing the master according to the embodiment.
[FIG. 3D] FIG. 3D is a cross-sectional view showing each step of the method for manufacturing the master according to the embodiment.
[FIG. 4] FIG. 4 is an explanatory diagram showing a general configuration of an exposure device according to the embodiment.
[FIG. 5] FIG. 5 is a block diagram showing a configuration of a formatter according to the embodiment.
[FIG. 6] FIG. 6 is an explanatory diagram showing an input image divided into a plurality of small regions according to the embodiment, which is an explanatory diagram describing division of the input image in which objects are drawn into the small regions.
[FIG. 7] FIG. 7 is an explanatory diagram showing a specific example of an exposure control signal according to the embodiment.
[FIG. 8] FIG. 8 is an explanatory diagram showing a specific example of an input image according to a modification example of the embodiment.
[FIG. 9] FIG. 9 is an explanatory diagram showing a specific example of an input image divided into a plurality of small regions according to the modification of the embodiment and a contrasting density of the partial image of the object.
[FIG. 10] FIG. 10 is an explanatory diagram showing a specific example of the exposure control signal according to the modification example of the embodiment.
[FIG. 11] FIG. 11 is an explanatory diagram showing a configuration example of the exposure device according to the embodiment.
[FIG. 12] FIG. 12 is an explanatory diagram showing another configuration example of the exposure device according to the embodiment.
[FIG. 13] FIG. 13 is an explanatory diagram showing an input image according to Example 1 of the present invention and an SEM image of a manufactured transferred obj ect.
[FIG. 14] FIG. 14 is an explanatory diagram showing an input image according to Example 2 of the present invention and an SEM image of a manufactured transferred obj ect.
[FIG. 15] FIG. 15 is an explanatory diagram showing an input image according to Example 3 of the present invention and an SEM image of a manufactured transferred obj ect.
[FIG. 16] FIG. 16 is an explanatory diagram showing an input image according to Example 4 of the present invention and an SEM image of a manufactured transferred obj ect.

### Description of Embodiments

Hereinafter, preferred embodiments of the present invention will be described in detail with reference to the appended drawings. Note that in the present specification and the drawings, structural elements that have substantially the same function and configuration are denoted with the same reference numerals, and repeated description is omitted.

### [1. Overview of master and transferred object]

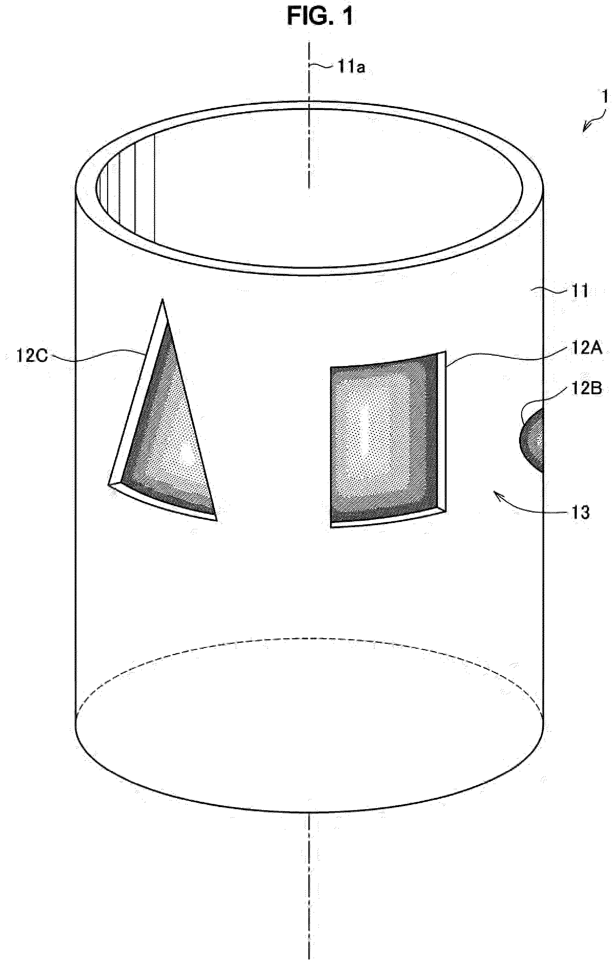

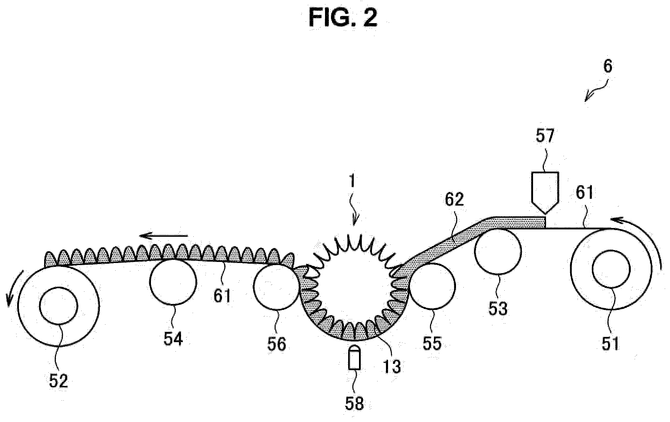

First, an overview of a master 1 manufactured by a method for manufacturing a master according to an embodiment of the present invention and a transferred object manufactured using the master 1 will be described with reference to FIGS. 1 and 2.

### [1.1. Configuration of master]

FIG. 1 is a perspective view schematically showing the master 1 manufactured by the method for manufacturing the master according to the present embodiment. As shown in FIG. 1, the master 1 according to the present embodiment includes a base member 11 having a concave-convex structure 13 formed on its outer circumferential surface.

The base member 11 is, for example, a cylindrical member. However, the shape of the base member 11 may be a hollow cylindrical shape having a cavity therein as shown in FIG. 1, or may be a solid columnar shape having no cavity therein. In addition, the material of the base member 11 is not particularly limited, and quartz glass (SiO₂) such as fused quartz glass or synthetic quartz glass or metal such as stainless steel can be used. The size of the base member 11 is not particularly limited, and, for example, may have an axial length of more than or equal to 100 mm, an outer diameter of more than or equal to 50 mm and less than or equal to 300 mm, and a thickness of more than or equal to 2 mm and less than or equal to 50 mm.

The concave-convex structure 13 is formed into any three-dimensional shape on the outer circumferential surface of the base member 11. The concave-convex structure 13 has a concave-convex pattern having any three-dimensional shape. For example, the concave-convex pattern of the concave-convex structure 13 may be a concave-convex pattern in which one or two or more concavities or convexities having any three-dimensional shape are arrayed regularly or irregularly. Alternatively, the concave-convex pattern of the concave-convex structure 13 may be a concave-convex pattern corresponding to a microlens array in which a plurality of microlenses are arrayed regularly or irregularly.

The concave-convex structure 13 is composed of at least one concavity or convexity having any planar shape. In the example of FIG. 1, the concave-convex structure 13 includes a plurality of concavities 12A, 12B, 12C, ... (which may hereinafter be collectively referred to as the "concavities 12") having various planar shapes. For example, the planar shape of the concavity 12 may be a figure including a curved line, such as a circle or an ellipse, a polygon such as a triangle or a rectangle, a linear shape or a strip shape such as a straight line or a curved line, a shape representing a character or a symbol, or the like. Herein, the planar shape of the concavity 12 (or convexity) refers to the shape of a figure obtained in a case where the concavity 12 (or convexity) is projected on a plane parallel to a central axis 11a of the base member 11, the figure being drawn by the concavity 12 (or convexity) on the projection plane. In other words, the planar shape of the concavity 12 (or convexity) refers to a two-dimensional shape when the concavity 12 (or convexity) is seen in plan view.

The method for manufacturing the master 1 according to the present embodiment enables the pattern of the concave-convex structure 13 having any three-dimensional shape to be formed on the outer circumferential surface of the base member 11 of the master 1 with high accuracy. Details of this method for manufacturing the master 1 according to the present embodiment will be described later.

Herein, the master 1 is a master for manufacturing a transferred object (such as a microlens array or a replica master for manufacturing a microlens array, for example) to which the concave-convex structure 13 has been transferred. The master 1 is a roll master to be used for roll-to-roll type imprinting, for example. The master 1 is provided for an imprinting transfer device of a roll-to-roll system. For example, with the master 1, a transferred object to which the concave-convex structure 13 formed on the outer circumferential surface of the master 1 has been transferred can be manufactured by a transfer device 6 shown in FIG. 2.

### [1.2. Method for manufacturing transferred object]

Next, a method for manufacturing a transferred object by transferring the concave-convex structure 13 of the master 1 to a resin layer 62 of a to-be-transferred object 61 in the roll-to-roll system using the transfer device 6 including the master 1 will be described with reference to FIG. 2. FIG. 2 is an explanatory diagram showing the transfer device 6 that manufactures a transferred object using the master 1 according to the present embodiment.

As shown in FIG. 2, the transfer device 6 includes the master 1, a base member supply roll 51, a take-up roll 52, guide rolls 53, 54, a nip roll 55, a peeling roll 56, a coating device 57, and a light source 58.

The base member supply roll 51 is a roll in which a sheet-like to-be-transferred object 61 is wound into a roll shape. The to-be-transferred object 61 is a base member of the transferred object. The to-be-transferred object 61 is a base member of a sheet form extending in a strip shape. The resin layer 62 is laminated on one surface of the to-be-transferred object 61. The take-up roll 52 is a roll that takes up the to-be-transferred object 61 having laminated thereon the resin layer 62 onto which the concave-convex structure 13 of the master 1 has been transferred. In addition, the guide rolls 53, 54 are rolls for conveying the to-be-transferred object 61. The nip roll 55 is a roll for bringing the to-be-transferred object 61 having laminated thereon the resin layer 62 into close contact with the cylindrical master 1. The peeling roll 56 is a roll for peeling off the to-be-transferred object 61 having laminated thereon the resin layer 62 from the master 1 after the concave-convex structure 13 of the master 1 is transferred to the resin layer 62.

The coating device 57 includes coating means such as a coater and coats the surface of the to-be-transferred object 61 with a photocurable resin composition. The resin layer 62 is formed on the surface of the to-be-transferred object 61 by coating the surface of the to-be-transferred object 61 with the photocurable resin composition using the coating device 57. The coating device 57 may be, for example, a gravure coater, a wire bar coater, a die coater, or the like. In addition, the light source 58 is a light source that emits light having a wavelength at which the photocurable resin composition can be cured and may be, for example, an ultraviolet lamp, or the like.

Note that the photocurable resin composition is a resin to be decreased in fluidity and cured when light having a predetermined wavelength is radiated thereto. Specifically, the photocurable resin composition may be an ultraviolet curable resin such as acrylic resin acrylate. In addition, the photocurable resin composition may contain an initiator, a filler, a functional additive, a solvent, an inorganic material, a pigment, an antistatic agent, a sensitizing dye, or the like according to necessity. Note that as the material of the resin layer 62, another energy ray-curable resin composition such as a thermosetting resin composition may be used instead of the photocurable resin composition described above.

Next, a method for manufacturing a transferred object using the transfer device 6 having the above configuration will be described.

First, the to-be-transferred object 61 is continuously fed out from the base member supply roll 51 and conveyed by the guide roll 53. Next, one surface of the fed to-be-transferred object 61 is coated with a photocurable resin composition by the coating device 57, and the resin layer 62 yet to be cured is laminated on the one surface of the to-be-transferred object 61. Furthermore, the to-be-transferred object 61 having laminated thereon the resin layer 62 yet to be cured is brought into close contact with the outer circumferential surface of the master 1 by the nip roll 55. Accordingly, the concave-convex structure 13 formed on the outer circumferential surface of the master 1 is transferred to the resin layer 62 yet to be cured. Thereafter, light such as ultraviolet light is radiated from the light source 58 to the resin layer 62 to which the concave-convex structure 13 has been transferred. Accordingly, the resin layer 62 yet to be cured is cured, and the shape of the concave-convex pattern transferred to the resin layer 62 after curing is stabilized. Then, the to-be-transferred object 61 having laminated thereon the resin layer 62 having been cured is peeled off from the master 1 by the peeling roll 56. Thereafter, the to-be-transferred object 61 peeled off from the master 1 is conveyed via the guide roll 54 and taken up by the take-up roll 52.

As described above, a transferred object to which the concave-convex structure 13 formed on the master 1 has been transferred can be continuously manufactured using the transfer device 6 of the roll-to-roll system.

In addition, it is also possible to manufacture a replica master by further transferring the transferred object to which the concave-convex structure 13 formed on the master 1 has been transferred to another to-be-transferred material. The replica master has the positions of concavities and convexities of the concave-convex structure 13 (what is called a tone of the concave-convex pattern) conformed to those of the master 1 and can be used as a reproduced master of the master 1. It is also possible to further transfer the replica master to a to-be-transferred object to produce a transferred object having the concave-convex structure 13 formed on its surface (that is, a transferred object obtained by transferring the concave-convex structure 13 three times from the master 1).

As described above, the roll master 1 according to the present embodiment has an outer circumferential surface on which the concave-convex structure 13 having any three-dimensional shape has been formed and enables continuous manufacturing of a transferred object to which the concave-convex structure 13 has been transferred. Accordingly, a large amount of transferred objects to which the concave-convex structure 13 has been transferred with high accuracy can be manufactured efficiently and inexpensively.

### [2. Method for manufacturing master]

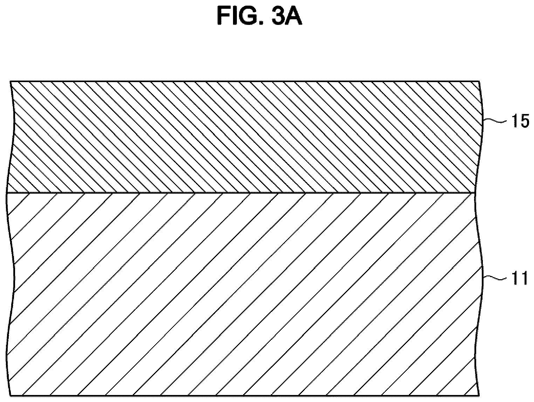

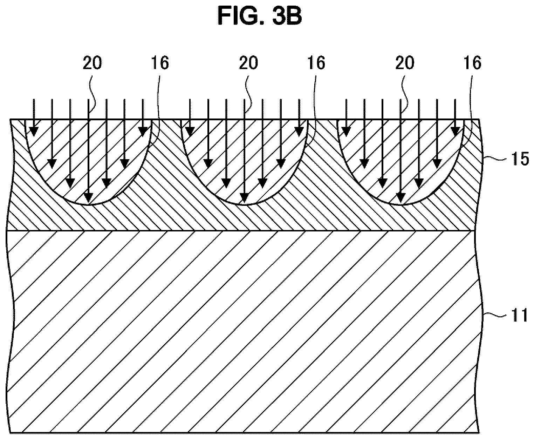

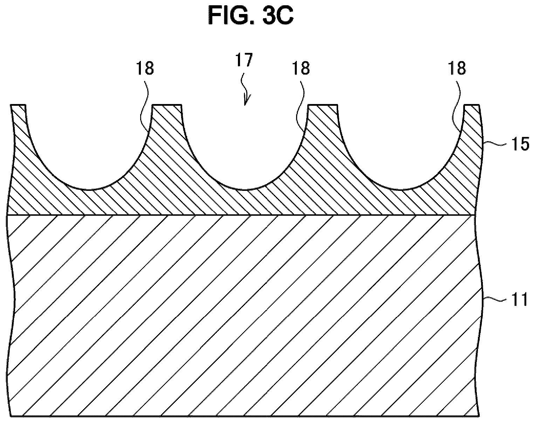

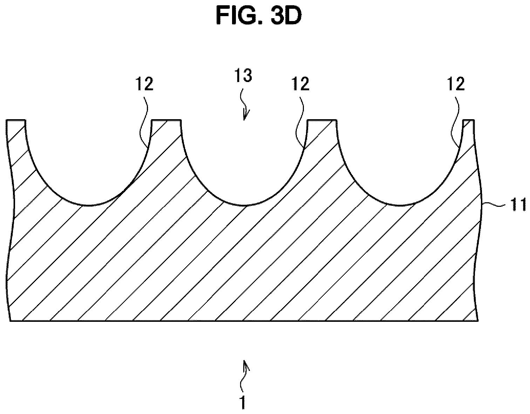

Next, the method for manufacturing the master 1 according to the present embodiment will be described with reference to FIGS. 3 to 12.

### [2.1. Overview of method for manufacturing master]

First, general steps (steps S10 to S50) of the method for manufacturing the master 1 using a manufacturing apparatus for the master 1 according to the present embodiment will be described with reference to FIGS. 3A to 3D. FIGS. 3A to 3D are cross-sectional views for describing the respective steps of the method for manufacturing the master 1 according to the present embodiment. Note that FIGS. 3A to 3D schematically show cross-sectional shapes when the base member 11 of the master 1 having a cylindrical shape is cut in the thickness direction.

The manufacturing apparatus for the master 1 according to the present embodiment includes, for example, a deposition device, an exposure device, a development device, an etching device, an exposure control device, other various control devices, and the like.

### (S10: Resist deposition step)

According to the method for manufacturing the master 1 according to the present embodiment, the deposition device of the manufacturing apparatus first forms the resist layer 15 on the outer circumferential surface of the base member 11 of the master 1 as shown in FIG. 3A.

In more detail, as shown in FIG. 3A, it is preferable to use a base member made of, for example, quartz glass or the like as the base member 11 of the master 1. The base member 11 is a roll-shaped base member having a cylindrical shape or a columnar shape. The resist layer 15 is deposited on the outer circumferential surface of this base member 11 using a resist material. Herein, it is preferable to use an organic resist as the material of the resist layer 15. As the organic resist, a novolac resist, a chemically amplified resist, or the like can be used, for example. Note that it is preferable to use a positive-type photoresist (for example, the product name: "AZ-P4210" manufactured by Merck & Co., Inc.) for the resist layer 15 in order to perform gradation exposure.

In the case where the organic resist is used as the material of the resist layer 15, the resist layer 15 is deposited on the outer circumferential surface of the base member 11 by, for example, spin coating, slit coating, dip coating, spray coating, screen printing, or the like. For example, it is preferable to coat the outer circumferential surface of the base member 11 with the organic resist by dip coating to deposit the resist layer 15 having a thickness of several micrometers to several tens of micrometers. The use of the organic resist enables the resist layer 15 which is relatively thick to be deposited.

### (S20: Exposure control signal generation step)

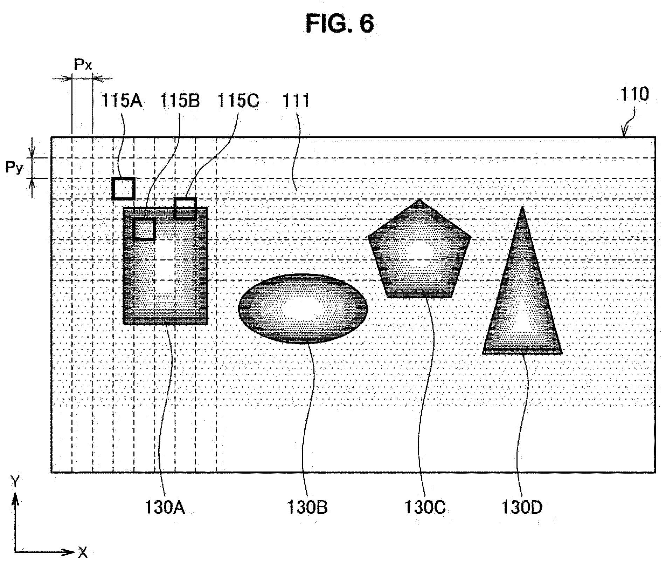

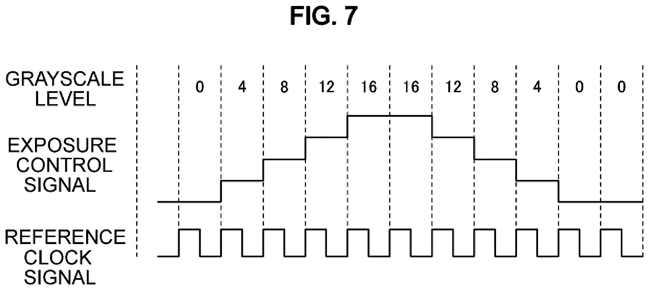

Then, a computer (for example, the exposure control device) of the manufacturing apparatus acquires an input image 110 (see FIG. 6) in which at least one object 130 is drawn and generates an exposure control signal (see FIG. 7) corresponding to the object 130 based on the input image 110. Details of the input image 110, the object 130, the exposure control signal, and the like will be described later.

### (S30: Exposure step)

Moreover, as shown in FIG. 3B, the exposure device of the manufacturing apparatus radiates the laser light 20 to the resist layer 15 based on the exposure control signal generated in S20 above. Accordingly, the resist layer 15 is exposed in a predetermined exposure pattern to form a latent image 16 corresponding to the object 130.

In more detail, as shown in FIG. 3B, the laser light 20 is radiated to the resist layer 15 by the exposure device to denature a portion of the resist layer 15 to which the laser light 20 has been radiated. Accordingly, the resist layer 15 is exposed, and a plurality of latent images 16 are formed on the resist layer 15. At the time of this exposure, the laser light as exposure light may be radiated to the resist layer 15 continuously or intermittently. In the case where the laser light 20 is radiated continuously, scanning exposure of continuously radiating the laser light 20 to the surface of the resist layer 15 while relatively moving the laser light 20 in the planar direction of the resist layer 15 may be performed, for example. Alternatively, in the case where the laser light 20 is radiated intermittently, a spot of the laser light 20 may be radiated intermittently to the surface of the resist layer 15 by turning radiation of the laser light 20 on/off while relatively moving the laser light 20 in the planar direction of the resist layer 15, for example. Whether to use continuous radiation or intermittent radiation of the laser light 20 may be selected as appropriate depending on the input image 110.

Herein, the exposure control device generates an exposure control signal corresponding to the object 130 based on the input image 110 in which the object 130 is drawn, as in S20 above. Radiation of the laser light 20 to the resist layer 15 of the base member 11 is controlled by the exposure control signal, and the intensity of the laser light 20 is modulated according to the three-dimensional shape of the object 130. Accordingly, the exposure device radiates the laser light 20 modulated in intensity according to the three-dimensional shape of the object 130 to the position on the surface of the resist layer 15 corresponding to the object 130. As a result, the resist layer 15 can be denatured at the position corresponding to the object 130 in conformity to the three-dimensional shape of the object 130. Accordingly, the plurality of latent images 16 respectively corresponding to the plurality of objects 130 in the input image 110 are formed on the resist layer 15. The three-dimensional shapes of the respective latent images 16 correspond to the three-dimensional shapes of the respective objects 130. Note that specific processing in which the exposure control device generates the exposure control signal based on the input image 110 will be described later.

### (S40: Development step)

Then, as shown in FIG. 3C, the development device of the manufacturing apparatus develops the resist layer 15 on which the above-described latent images 16 have been formed. Accordingly, a resist pattern 17 corresponding to the objects 130 is formed on the resist layer 15.

In more detail, as shown in FIG. 3C, the development device drops a developing solution onto the resist layer 15 on which the latent images 16 have been formed in S30 above to develop the resist layer 15. Accordingly, the resist pattern 17 having a three-dimensional concave-convex structure is formed on the resist layer 15. This resist pattern 17 is composed of a plurality of concavities 18 having a three-dimensional shape. The three-dimensional shapes of the plurality of concavities 18 respectively correspond to the three-dimensional shapes of the respective objects 130. The depth of the concavity 18 may be such that the deepest portion of the concavity 18 reaches or does not reach the surface of the base member 11.

Note that in the case where the resist layer 15 is the positive-type resist, the exposed portion exposed to the laser light 20 has a higher rate of dissolution in the developing solution than an unexposed portion and is therefore removed by development treatment. Accordingly, as shown in FIG. 3C, the resist pattern 17 obtained by removing the portions of the latent images 16 in the resist layer 15 is formed on the resist layer 15. On the other hand, in a case where the resist layer 15 is a negative-type resist, the exposed portion exposed to the laser light 20 has a lower rate of dissolution in the developing solution than the unexposed portion, so that the unexposed portion is removed by the development treatment. Accordingly, a resist pattern (not shown) in which the portions of the latent images 16 remain is formed on the resist layer 15.

### (S50: Etching step)

Thereafter, as shown in FIG. 3D, the etching device of the manufacturing apparatus etches the base member 11 using, as a mask, the resist layer 15 on which the resist pattern 17 has been formed. Accordingly, a concave-convex pattern (that is, the concave-convex structure 13) composed of the concavities 12 corresponding to the objects 130 is formed on the outer circumferential surface of the base member 11.

In more detail, as shown in FIGS. 3C and 3D, the base member 11 is etched using, as a mask, the resist layer 15 on which the resist pattern 17 corresponding to the objects 130 has been formed in S40 above. Accordingly, the concave-convex structure 13 (concave-convex pattern) composed of the plurality of concavities 12 is formed on the outer circumferential surface of the base member 11. The concave-convex shape of the concave-convex structure 13 shown in FIG. 3D corresponds to the concave-convex shape of the resist pattern 17 shown in FIG. 3C and is equivalent to an inverted shape of the three-dimensional shapes of the plurality of objects 130 transferred from the master 1 to the transferred object. The three-dimensional shapes of the plurality of concavities 12 constituting the concave-convex structure 13 respectively correspond to the three-dimensional shapes of the objects 130 transferred from the master 1 to the transferred obj ect.

Note that for etching of the base member 11, either dry etching or wet etching can be used. For example, in a case where the material of the base member 11 is quartz glass (SiO₂), dry etching through use of a fluorocarbon gas (for example, CHF₃) or wet etching through use of hydrofluoric acid or the like can be utilized to etch the base member 11.

### [2.2. Details of exposure control signal generation step (S20)]

Next, the exposure control signal generation step (S20) in the method for manufacturing the master 1 according to the present embodiment will be described in more detail with reference to FIGS. 6 and 7.

In the exposure control signal generation step (S20), a computer of the manufacturing apparatus for the master 1, for example, the exposure control device, generates an exposure control signal for exposing the base member 11 of the master 1 based on the input image 110 in which the objects 130 are drawn.

### (S21: Input image acquisition step)

Specifically, first, as shown in FIG. 6, the input image 110 in which at least one object 130A, 130B, 130C, 130D (which may hereinafter be collectively referred to as the object 130) having three-dimensional shapes are two-dimensionally drawn is input to the exposure control device.

Herein, the input image 110 is, for example, a rectangular image obtained by opening up the outer circumferential surface of the cylindrical master 1 into a flat surface. The input image 110 may be, for example, a grayscale image that two-dimensionally represents the three-dimensional concave-convex structure 13 formed on the outer circumferential surface of the master 1. In the input image 110, the plurality of objects 130 constituting the plurality of concavities 12 or convexities of the concave-convex structure 13 are expressed two-dimensionally.

The object 130 is a structural body having any three-dimensional shape (for example, a convex structural body or concave structural body). The input image 110 includes a planar image that two-dimensionally expresses the object 130 having the three-dimensional shape. The planar shape of the object 130 may be any shape such as, for example, a figure including a curved line, such as a circle or an ellipse, a polygon such as a triangle or a rectangle, a linear shape or a strip shape such as a straight line or a curved line, a shape representing a character or a symbol, or the like. In the input image 110 in the example of FIG. 6, the rectangular object 130A, the elliptical object 130B, the pentagonal object 130C, and the triangular object 130D are drawn.

The input image 110 is an image that expresses a change in height of the three-dimensional shape of the object 130 using a contrasting density of the image. For example, the input image 110 preferably is a grayscale image that expresses the change in height of the three-dimensional shape of the object 130 using the contrasting density (that is, levels of grayscale) of the image. In the example of FIG. 6, a lighter colored portion (a region closer to white in grayscale) in the object 130 represents a higher portion of the object 130, and a darker colored portion (a region closer to black in grayscale) in the object 130 represents a lower portion of the object 130.

Note that the levels of grayscale used in the input image 110 preferably are 2 to 65,536 levels (1 to 16 bits) and more preferably are 2 to 256 levels (1 to 8 bits), for example. However, the present invention is not limited to this example, and the levels of grayscale may be any levels of two levels (1 bit) or more. In the present embodiment, a 256-level grayscale is used, for example. The larger number of levels of grayscale there are, the more finely the three-dimensional shape of the object 130 can be expressed advantageously, whereas the amount of data processing required for processing of analyzing the input image 110, processing of generating the exposure control signal, the exposure control processing, and the like increases disadvantageously. Therefore, the levels of grayscale of the input image 110 preferably are set at more than or equal to levels by which the amount of data processing required for the image analysis processing for the input image 110 and the like is reduced to be less than or equal to an allowable range of a data processing capacity of a formatter 40 and fineness and smoothness of a desired three-dimensional shape are obtained. Accordingly, the three-dimensional shape of the object 130 can be reproduced on the master 1 with high accuracy.

### (S22: Input image division step)

Then, the exposure control device divides the input image 110 into a plurality of small regions 115 as shown in FIG. 6. In the present embodiment, when divided into the plurality of small regions 115, the input image 110 is regularly divided in the X direction (lateral direction) and the Y direction (vertical direction) of the input image 110. In the example of FIG. 6, the input image 110 is regularly divided vertically and laterally using square lattice-shaped grid lines.

Herein, the size (for example, the area or the length of one side) of the divided small regions 115 is adjusted in conformity to the size of the spot (for example, a radiated area or spot diameter) of the laser light 20. In particular, the size of the small regions 115 preferably is smaller than the size of the spot of the laser light 20. The resist pattern 17 corresponding to the three-dimensional shapes of the objects 130 can be suitably formed by this exposure method of radiating the spot of the laser light 20 to each of the small regions 115.

Note that the form of dividing the input image 110 into the small regions 115 is not limited to the example of the square lattice as described above, and the input image 110 may be regularly divided using grid lines of a rectangular lattice shape, a triangular lattice shape, a hexagonal lattice shape, or the like, for example. Alternatively, the input image 110 may be irregularly divided using a dividing line having any shape such as a straight line or a curved line.

### (S23: Exposure control signal generation step)

Then, as shown in FIG. 7, the exposure control device generates the exposure control signal for exposing the resist layer 15 based on a partial image in each of the small regions 115 of the above-described input image 110. The partial image is equivalent to an image in each of the small regions 115 when the input image 110 is divided into the plurality of small regions 115.

Herein, a specific example of a method for generating the exposure control signal will be described. First, based on whether or not the object 130 is included in each of the small regions 115 obtained by dividing the input image 110, the exposure control device determines whether or not to radiate the laser light 20 to each of the small regions 115. As shown in FIG. 6, a region in which the object 130 is drawn (an image region representing a concave-convex portion in which the object 130 is present) and a region in which the object 130 is not drawn (an image region representing a flat portion in which the object 130 is not present) are present in the input image 110. Therefore, as shown in FIG. 6, among the plurality of small regions 115 obtained by dividing the input image 110, some of the small regions, 115B and 115C, include the object 130, and other some small regions, 115A, do not include the object 130. Moreover, in the small regions 115B and 115C including the object 130, the contrasting density (the level of grayscale) of the partial image changes in accordance with the height of the three-dimensional shape of the object 130 as compared with the small region 115A not including the object 130.

Thus, the exposure control device analyzes the input image 110 to evaluate whether or not the object 130 is included in each of the small regions 115 of the input image 110. Moreover, as a result of the evaluation, the exposure control device determines that the laser light 20 is to be radiated to the small regions 115B and 115C in which the object 130 is included. On the other hand, the exposure control device determines that the laser light 20 is not to be radiated to the small region 115A in which the object 130 is not included.

Furthermore, the exposure control device analyzes the input image 110 to evaluate the contrasting density of the partial image (for example, the level of grayscale of the partial image) of the object 130 in each of the small regions 115 in which the object 130 is included, as shown in FIG. 7. Then, the exposure control device determines in a stepwise manner the intensity of the laser light 20 to be radiated to each of the small regions 115 based on the evaluated contrasting density (for example, the level of grayscale of the partial image). For example, as the partial image of the object 130 in each of the small regions 115 has a lighter color, which is closer to white, and has a higher level of grayscale (that is, as the height of the object 130 in each of the small regions 115 is greater), the intensity of the laser light 20 to be radiated to each of the small regions 115 is determined to be a higher intensity. On the other hand, as the partial image of the object 130 in each of the small regions 115 has a darker color, which is closer to black, and has a lower level of grayscale (as the height of the object 130 in each of the small regions 115 is smaller), the intensity of the laser light 20 to be radiated to each of the small regions 115 is determined to be a lower intensity.

In addition, when evaluating the contrasting density (the level of grayscale) of the partial image in each of the small regions 115 as described above, the exposure control device preferably uses a level corresponding to an average value of the contrasting densities of the partial image in each of the small regions 115 as an evaluation result of the level of grayscale in each of the small regions 115. For example, there are some cases in which the height of the object 130 significantly changes in a certain one of the small regions 115, and the partial image in the one of the small regions 115 has levels of a plurality of grayscales different from each other. In this case, an average value of the levels of the plurality of grayscales (for example, an average value in the proportion of area or an average value in the proportion of the number of pixels) in the one of the small regions 115 may be used as the level of grayscale in the entire partial image in the small region 115. Accordingly, the level of grayscale of the partial image in each of the small regions 115 can be appropriately evaluated, and in accordance with the evaluated level, the intensity of the laser light 20 to be radiated to each of the small regions 115 can be appropriately determined. This enables the resist pattern 17 and the concave-convex pattern (the concave-convex structure 13) corresponding to the three-dimensional shape of the object 130 included in the input image 110 to be formed with high accuracy.

In the foregoing manner, the exposure control device evaluates, for each of the small regions 115 of the input image 110, the presence/absence of the object 130 and the degree of the contrasting density (the level of grayscale) of the partial image of the object 130 included in the small region 115. Then, the exposure control device determines in a plurality of stages the intensity of the laser light 20 to be radiated to each of the small regions 115 in accordance with the contrasting density of the partial image of the object 130 included in each of the small regions 115. Then, the exposure control device generates an exposure control signal corresponding to the object 130 included in the input image 110 based on the determination result.

The exposure control signal is a control signal for controlling the laser light 20 (exposure light) to be used for exposing the resist layer 15 deposited on the outer circumferential surface of the base member 11 of the master 1. In the present embodiment, the intensity of the laser light 20 to be radiated to each of the small regions 115 of the resist layer 15 is modulated in conformity to a difference in height of the three-dimensional shape of the object 130 in each of the small regions 115 (that is, the contrasting density of the partial image of the object 130). For this purpose, the exposure control signal is generated as a signal having a step-like waveform that changes in signal level in a stepwise manner in accordance with the contrasting density (the level of grayscale) of the partial image of the object 130 in each of the small regions 115 as shown in FIG. 7. By using this exposure control signal, the intensity of the laser light 20 to be radiated to a region corresponding to each of the small regions 115 in the surface of the resist layer 15 can be modulated in accordance with the level of grayscale of the partial image of the object 130 in each of the small regions 115 of the input image 110. As described, the exposure control signal is configured as a modulation signal (an exposure laser intensity modulation signal) for modulating the intensity of exposure laser light.

The exposure control signal generation step (S20) in the method for manufacturing the master 1 according to the present embodiment has been described above in detail.

Thereafter, in the exposure step (S30: see FIG. 3B), the exposure device radiates the laser light 20 having the intensity modulated based on the above-described exposure control signal to the resist layer 15. Accordingly, the resist layer 15 is exposed in an exposure pattern corresponding to the above-described exposure control signal.

In detail, in the exposure step, the exposure device modulates the intensity of the laser light 20 for each of the small regions 115 in accordance with the contrasting density of the partial image of the object 130 based on the exposure control signal and radiates the modulated laser light 20 to the region corresponding to each of the small regions 115 in the surface of the resist layer 15. Accordingly, the latent image 16 corresponding to the three-dimensional shape of each of the objects 130 is formed on the surface of the resist layer 15 in an exposure pattern corresponding to the plurality of objects 130.

Then, in the development step (S40: see FIG. 3C), the development device develops the resist layer 15 after the exposure. Accordingly, the resist pattern 17 corresponding to the three-dimensional shapes of the plurality of objects 130 can be formed on the resist layer 15. In the resist pattern 17, the depth of the concavity 18 of the resist pattern 17 changes for each of the small regions 115 in the surface of the resist layer 15 in accordance with the contrasting density of the partial image of the above-described object 130.

Thereafter, in the etching step (S50: see FIG. 3D), the etching device etches the base member 11 using, as a mask, the resist layer 15 on which the resist pattern 17 has been formed. Accordingly, the concave-convex structure 13 (concave-convex pattern) composed of the plurality of concavities 12 respectively corresponding to the three-dimensional shapes of the plurality of objects 130 can be formed on the outer circumferential surface of the base member 11 of the master 1. Each of the concavities 12 of the concave-convex structure 13 has an inverted shape of the three-dimensional shape of each of the objects 130.

By manufacturing the master 1 in the foregoing manner, the concave-convex structure 13 corresponding to the objects 130 having any three-dimensional shapes can be formed on the outer circumferential surface of the master 1 with high accuracy. Then, by transferring the concave-convex structure 13 of the master 1 thus manufactured to the surface of the to-be-transferred object, the transferred object or the replica master can be manufactured. Thus, the transferred object or the replica master on which the pattern of the concave-convex structure 13 of the object 130 having a desired three-dimensional shape has been formed with high accuracy can be mass-produced efficiently and inexpensively.

Note that in the conventional art described in the above-mentioned Patent Literature 2, the intensity of laser light to be radiated when the resist layer of the master is exposed is not modulated and has a constant intensity. Thus, it is difficult to form, on the surface of the resist layer, a resist pattern of a concave-convex structure having a three-dimensional shape corresponding to an object having a three-dimensional shape. In addition, in the conventional art, a thin resist layer having a thickness of several tens of nanometers to several hundreds of nanometers is exposed through thermal lithography through use of a resist layer made of an inorganic resist, thereby forming the resist pattern. Furthermore, in the thermal lithography in the conventional art, when absorbed heat of the resist layer due to laser radiation at the time of exposure exceeds a certain threshold value, a chemical reaction of the inorganic resist proceeds rapidly. Thus, it is difficult to control the depth of the resist pattern to be formed in the thin inorganic resist layer, and a resist pattern having a desired three-dimensional shape cannot be generated with high accuracy.

In contrast, the method for manufacturing the master 1 according to the present embodiment modulates the intensity of the laser light 20 when each of the small regions 115 of the resist layer 15 is exposed in conformity to the contrasting density of the partial image of the object 130 in each of the small regions 115 of the input image 110. The contrasting density of the partial image in this input image 110 corresponds to the height of the three-dimensional shape (the concave-convex structure 13) of the object 130 actually formed on the outer circumferential surface of the master 1. Therefore, the resist pattern 17 having a three-dimensional shape corresponding to the objects 130 can be formed on the surface of the resist layer 15 with high accuracy.

Moreover, in the present embodiment, the thick resist layer 15 made of an organic resist containing a photosensitive material and having a thickness of several micrometers to several tens of micrometers is used, and the resist layer 15 is exposed through photolithography. The organic resist can be deposited more thickly than the inorganic resist. In addition, in the organic resist, a photoreaction of the contained photosensitive material proceeds in reaction in accordance with the light intensity of laser light. Therefore, in the exposure step according to the present embodiment, photolithography through use of the relatively thick resist layer 15 made of the organic resist can be applied to cause the photoreaction of the resist layer 15 at the time of exposure to gradually proceed in the depth direction. In addition, by modulating the intensity of the laser light 20 radiated at the time of exposure, the depth and three-dimensional shape of the latent image 16 formed on the resist layer 15 can be suitably controlled. Therefore, as shown in FIGS. 3B to 3C, the resist pattern 17 having a three-dimensional shape corresponding to the objects 130 having a desired three-dimensional shape can be formed with high accuracy. Thus, as shown in FIG. 3D, the concave-convex structure 13 (concave-convex pattern) having a three-dimensional shape corresponding to the object 130 having the desired three-dimensional shape can also be formed on the outer circumferential surface of the base member 11 of the master 1 with high accuracy.

### [2.3. Exposure device and exposure method]

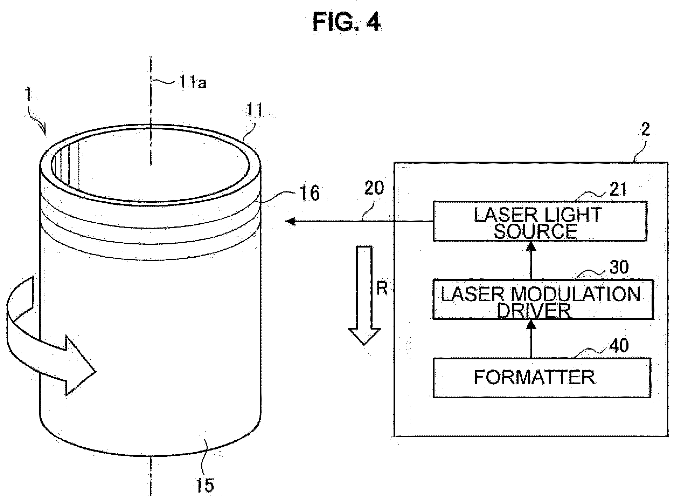

Next, the exposure device 2 and the exposure method to be used in the method for manufacturing the master 1 according to the present embodiment will be described in more detail with reference to FIGS. 4 to 7. FIG. 4 is an explanatory diagram showing a general configuration of the exposure device 2 according to the present embodiment.

As shown in FIG. 4, the exposure device 2 according to the present embodiment is a device for exposing the resist layer 15 deposited on the outer circumferential surface of the base member 11 of the roll master 1. The exposure device 2 includes a laser light source 21, a laser modulation driver 30, and the formatter 40.

The laser light source 21 is a light source that emits the laser light 20 and is a solid-state laser, a semiconductor laser, or the like, for example. The wavelength of the laser light 20 is not particularly limited and may be a wavelength in a blue light band of 400 nm to 500 nm, for example.

The formatter 40 is equivalent to the above-mentioned exposure control device. The formatter 40 generates the exposure control signal for radiating the laser light 20 to the resist layer 15 based on the input image 110 in which the object 130 is drawn. For example, the formatter 40 may generate the exposure control signal for radiating the laser light 20 to the position corresponding to the object 130 in the surface of the resist layer 15 of the base member 11. Accordingly, the latent image 16 corresponding to the object 130 having any shape is formed on the resist layer 15 on the base member 11. Note that the formatter 40 may control radiation of the laser light 20 to the base member 11 by controlling emission of the laser light 20 by the laser light source 21, or may control radiation of the laser light 20 to the base member 11 by controlling the radiated position such that the laser light 20 is not radiated to the base member 11.

The laser modulation driver 30 is a driver that controls radiation of the laser light 20 by the laser light source 21. The laser modulation driver 30 has a function of modulating the intensity (power) of the laser light 20 to be radiated from the laser light source 21. The exposure control signal generated by the above-described formatter 40 is input to the laser modulation driver 30. The laser modulation driver 30 modulates the intensity of the laser light 20 to be radiated from the laser light source 21 based on the exposure control signal. As shown in FIG. 7, for example, the exposure control signal has a step-like waveform, the signal level of which changes in a stepwise manner in accordance with the contrasting density (the level of grayscale) of the partial image of the object 130 included in each of the small regions 115 of the above-described input image 110. Thus, the laser modulation driver 30 modulates the intensity of the laser light 20 to be radiated from the laser light source 21 in conformity to the signal level of the exposure control signal having the step-like waveform. As a result, the laser light 20, the intensity of which has been modulated in accordance with the contrasting density of the partial image of the object 130, is radiated from the laser light source 21 to the base member 11, so that the resist layer 15 is exposed.

The exposure device 2 having the configuration as described above radiates the laser light 20 to the resist layer 15 of the base member 11 to denature part of the resist layer 15, thereby forming the latent image 16 (see FIG. 3B). At the time of the exposure, the exposure device 2 may, for example, intermittently or continuously radiate the laser light 20 along a spiral track to the resist layer 15 formed on the outer circumferential surface of the cylindrical base member 11 to spirally expose the resist layer 15. In this case, the exposure device 2 may radiate the laser light 20 to the base member 11 by scanning the base member 11 with the laser light 20 in one direction (R direction) along the central axis 11a of the base member 11 at a constant speed while rotating the base member 11 at a constant speed using the central axis 11a of the cylindrical base member 11 as the rotation axis. Accordingly, the laser light 20 is radiated intermittently or continuously to the surface of the resist layer 15 along the spiral track sequentially from one side to the other side of the base member 11 in the axial direction, and the latent image 16 having a desired shape is formed at a necessary position in the surface of the resist layer 15.

In the exposure device 2 according to the present embodiment, the laser modulation driver 30 controls radiation of the laser light 20 while modulating the intensity of the laser light 20 based on the exposure control signal generated by the formatter 40. Accordingly, the depth and shape of the resist layer 15 exposed to the laser light 20 can be changed to form the latent image 16 having a three-dimensional shape corresponding to the object 130 on the resist layer 15.

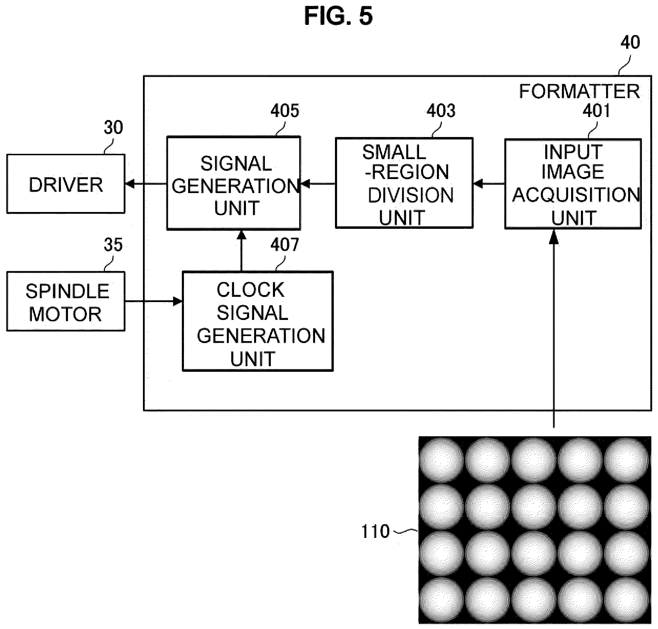

Next, a functional configuration of the formatter 40 (exposure control device) according to the present embodiment will be described with reference to FIG. 5. FIG. 5 is a block diagram showing the configuration of the formatter 40 according to the present embodiment.

As shown in FIG. 5, the formatter 40 according to the present embodiment generates the exposure control signal for controlling radiation of the laser light 20 and a clock signal. The formatter 40 includes an input image acquisition unit 401, a small-region division unit 403, a signal generation unit 405, and a clock signal generation unit 407.

The input image acquisition unit 401 acquires the input image 110 (see FIG. 6) in which the object 130 is drawn. The input image 110 is, for example, an image equivalent to a developed view obtained by opening up the outer circumferential surface of the cylindrical base member 11 in the axial direction of the base member 11 into a flat surface. In addition, the planar shape of the object 130 drawn in the input image 110 may be, for example, a figure including a curved line, such as a circle or an ellipse, a polygon such as a triangle or a rectangle, a linear shape or a strip shape such as a straight line or a curved line, a shape representing a character or a symbol, or the like.

The small-region division unit 403 divides the input image 110 acquired by the input image acquisition unit 401 into the plurality of small regions 115 having a predetermined shape and size. Specifically, the small-region division unit 403 divides the input image 110 into the plurality of small regions 115 at a predetermined lattice interval. For example, as shown in FIG. 6, the small-region division unit 403 divides the input image 110 at a predetermined interval Px in a direction (the X direction of the input image 110) corresponding to the circumferential direction of the base member 11 and divides the input image 110 at a predetermined interval Py in a direction (the Y direction of the input image 110) corresponding to the axial direction of the base member 11. Note that the interval Px and the interval Py may be the same or different.

Herein, the size (for example, the above-described intervals Px, Py) of the divided small regions 115 preferably is smaller than the size of the spot (for example, the spot diameter) of the laser light 20. Accordingly, the latent images 16 formed by radiation of the laser light 20 can be overlapped on each other without gaps between adjacent ones of the small regions 115. In other words, the exposure device 2 can perform exposure so as to fill in a position corresponding to the object 130 by overlapping a plurality of spots of the laser light 20. For example, in a case where the spot of the laser light 20 has a diameter of about 200 nm, the intervals Px, Py of the small regions 115 may be 100 nm, and the small regions 115 may be a 100-nm×100-nm square. In addition, the shape of the small regions 115 is not limited to the example of the square and may be any shape such as a rectangular shape, a triangular shape, a polygonal shape, or the like as mentioned above.

Moreover, the small-region division unit 403 evaluates whether or not the object 130 is included in each of the small regions 115. The small-region division unit 403 also evaluates the degree of the contrasting density (the level of grayscale) of the partial image of the object 130 in each of the small regions 115 in which the object 130 is included.

Herein, the function of the small-region division unit 403 will be described in more detail with reference to FIG. 6. FIG. 6 is an explanatory diagram showing the input image 110 divided into the plurality of small regions 115. Note that in FIG. 6, the X direction corresponds to the circumferential direction of the outer circumferential surface of the base member 11, and the Y direction corresponds to the axial direction of the base member 11.

As shown in FIG. 6, the small-region division unit 403 divides the input image 110 including the objects 130A, 130B, 130C, and 130D at the interval Px in the X direction and at the interval Py in the Y direction. Accordingly, the input image 110 is divided into the small regions 115 having a lattice shape. The small-region division unit 403 also evaluates whether or not the object 130 is included in each of the small regions 115. For example, the small-region division unit 403 evaluates that the small region 115Ais a small region in which the object 130 is not included and evaluates that the small regions 115B and 115C are small regions in which the object 130 is included. Note that in a case where the object 130 is drawn in each of the small regions 115 even slightly, the small-region division unit 403 may evaluate that the object is included in the small region 115. Alternatively, in a case where the object 130 is drawn in a region of a predetermined area or more in each of the small regions 115, the small-region division unit 403 may evaluate that the object 130 is included in the small region 115.

Note that an exposure region 111 may be set in the input image 110 in order to instruct that only some regions of the input image 110 are to be exposed. In this case, the small-region division unit 403 may evaluate, only for the small regions 115 in the exposure region 111 of the input image 110, whether or not the object 130 is included.

The signal generation unit 405 generates the exposure control signal for controlling radiation of the laser light 20. Specifically, the signal generation unit 405 determines whether or not to radiate the laser light 20 to a region corresponding to each of the small regions 115 in the resist layer 15 based on an evaluation result of the above-described small-region division unit 403. The signal generation unit 405 further evaluates in a stepwise manner the contrasting density (for example, the level of grayscale) of the partial image of the object 130 in each of the small regions 115 in which the object 130 is included. Then, based on the evaluation result, the signal generation unit 405 determines in a stepwise manner the intensity of the laser light 20 to be radiated to each of the small regions 115. The signal generation unit 405 further generates an exposure control signal indicating the intensity and timing of the laser light 20 to be radiated to each of the small regions 115 based on the evaluation result (for example, data representing the intensity of the laser light 20 to be radiated to each of the small regions 115). At this time, the signal generation unit 405 converts the data representing the intensity of the laser light 20 determined as described above into the exposure control signal using the clock signal generated by the clock signal generation unit 407. The exposure control signal thus generated by the signal generation unit 405 is transmitted to the driver 30 that controls the laser light source 21. The driver 30 controls radiation of the laser light 20 by the laser light source 21 based on the exposure control signal.

### [2.4. Specific example of input image and exposure control signal]

Herein, a specific example of the method for generating the exposure control signal based on the input image 110 will be described in more detail with reference to FIGS. 6 and 7. Note that FIG. 7 is an explanatory diagram showing a specific example of the exposure control signal corresponding to a surrounding image of the object 130A in the input image 110 shown in FIG. 6.

As shown in FIGS. 6 and 7, the signal generation unit 405 evaluates, for each row in the X direction of the input image 110, the contrasting density (for example, the level of grayscale) of the partial image in each of the small regions 115 and based on the evaluation result, determines the intensity of the laser light 20 to be radiated to each of the small regions 115.

For example, the signal generation unit 405 first selects the uppermost row of the input image 110 (or the exposure region 111) and evaluates the contrasting density (for example, the level of grayscale) of the partial image in each of the small regions 115 successively from the leftmost small region 115 to the rightmost small region 115 in this row (that is, in the positive direction of the X axis).

At this time, the signal generation unit 405 assigns "0" as the level of grayscale to the small regions 115 in which the object 130 is not included. On the other hand, the signal generation unit 405 assigns, to the small regions 115 in which the object 130 is included, numeric values (for example, in the example of FIG. 7, twenty-four levels of "0 to 23") of the levels of grayscale in accordance with the contrasting density of the partial image of the object 130 in the small regions 115. Accordingly, the signal generation unit 405 evaluates the level of grayscale of each of the small regions 115 successively from the leftmost small region 115 to the rightmost small region 115 in one row.

Thereafter, the signal generation unit 405 selects an immediately underlying subsequent row and performs processing similar to the foregoing in that row to evaluate the level of grayscale of each of the small regions 115 in that row. The signal generation unit 405 further repeats this evaluation processing successively from an upper row to a lower row (in the negative direction of the Y direction), thereby evaluating the levels of grayscale of the plurality of small regions 115 in the entire region of the input image 110 (or the exposure region 111).

Note that the order in which the signal generation unit 405 evaluates the levels of grayscale in each row in the X direction of the input image 110 is set based on a direction in which the base member 11 rotates. Thus, the signal generation unit 405 may evaluate the levels of grayscale successively from the rightmost small region 115 to the leftmost small region 115 (in the negative direction of the X axis) for each row in the X direction depending on the direction in which the base member 11 rotates. In addition, the order in which the signal generation unit 405 evaluates the levels of grayscale in the Y direction of the input image 110 is set based on a direction in which the base member 11 is scanned with the laser light 20. Thus, the signal generation unit 405 may evaluate the levels of grayscale successively from a lower row to an upper row of the input image 110 (in the positive direction of the Y axis) depending on the direction in which the base member 11 is scanned with the laser light 20.

In addition, as shown in FIG. 7, the signal generation unit 405 converts data representing the above-described evaluation result of the level of grayscale of each of the small regions 115 (equivalent to the data representing the intensity of the laser light 20 to be radiated to each of the small regions 115) into the exposure control signal using the clock signal acquired from the clock signal generation unit 407. For example, the clock signal is a rectangular wave signal having a predetermined frequency. In addition, the data representing the evaluation result of the level of grayscale is, for example, numeric value data representing the level of grayscale assigned to each of the small regions 115 of the input image 110.

As shown in FIG. 7, the exposure control signal is a signal having a step-like waveform. The signal level of the exposure control signal increases/decreases in a stepwise manner in accordance with the level of grayscale representing the contrasting density of the partial image in each of the small regions 115. In the example of FIG. 7, for the small region 115 whose level of grayscale has been evaluated as " 16", the exposure control signal has the highest signal level.

In addition, the signal generation unit 405 generates the exposure control signal in synchronization with the clock signal. For example, the exposure control signal is generated such that rise and fall times of the exposure control signal coincide with either a rise time or a fall time of the clock signal. In the example of FIG. 7, the exposure control signal is generated such that the rise and fall of the exposure control signal coincide with the rise of the clock signal.

The clock signal generation unit 407 generates a clock signal to be a reference of the exposure control signal. Specifically, the clock signal generation unit 407 acquires, from a spindle motor 35 that rotates the base member 11, a rotation control signal for controlling rotation of the spindle motor 35 and generates a clock signal having a predetermined frequency based on the rotation control signal.

Herein, the rotating speed of the spindle motor 35 that rotates the base member 11 is not constant all the time and fluctuates even in a case where a constant rotating speed is set. Thus, in a case where the rotation control signal that controls rotation of the spindle motor 35 and the exposure control signal that controls radiation of the laser light 20 are not in synchronization, one rotation of the spindle motor 35 and one period of the exposure control signal might not coincide with each other. In such a case, the position of the outer circumferential surface of the base member 11 to which the laser light 20 is radiated is offset per rotation of the base member 11, so that the concave-convex pattern corresponding to the object 130 might not be formed at an accurate position on the outer circumferential surface of the base member 11.

Thus, the exposure device 2 according to the present embodiment generates the clock signal from the rotation control signal for controlling rotation of the spindle motor 35 and based on the clock signal, generates the exposure control signal for controlling radiation of the laser light 20, as mentioned above. Accordingly, the rotation control signal and the exposure control signal are brought into synchronization. Therefore, the position of the outer circumferential surface of the base member 11 to which the laser light 20 is to be radiated is not offset per rotation of the base member 11, which enables the concave-convex pattern corresponding to the object 130 to be formed at an accurate position on the outer circumferential surface of the base member 11.

Note that a method for bringing the rotation control signal and the exposure control signal into synchronization is not limited to the above-described example. For example, the clock signal generation unit 407 may transmit the clock signal to be the reference to the spindle motor 35 and the signal generation unit 405, respectively. In such a case, the spindle motor 35 generates the rotation control signal that controls rotation of the spindle motor 35 based on the clock signal, and the signal generation unit 405 generates the exposure control signal based on the clock signal. This method can also bring the rotation control signal that controls rotation of the spindle motor 35 and the exposure control signal that controls radiation of the laser light 20 into synchronization.

The functional configuration of the formatter 40 that generates the exposure control signal that controls radiation of the laser light 20 has been described above. This formatter 40 enables the exposure control signal corresponding to the three-dimensional shape of any object 130 to be suitably generated.

Note that the function of this formatter 40 is achieved by cooperation of software and hardware. For example, the formatter 40 may include a CPU (Central Processing Unit), a ROM (Read Only Memory), a RAM (Random Access Memory), and the like connected to one another with a bridge to achieve the above-described function by these types of hardware.

For example, the CPU functions as an arithmetic processing unit and a control device to control overall operation in the formatter 40 in accordance with various programs. The ROM stores programs to be used by the CPU and arithmetic parameters, and the RAM temporarily stores programs to be used in execution of the CPU, parameters that vary as appropriate in execution thereof, and the like. Accordingly, the CPU can execute the functions of the input image acquisition unit 401, the small-region division unit 403, the signal generation unit 405, and the clock signal generation unit 407, for example.

### [2.5. Another specific example of input image and exposure control signal]

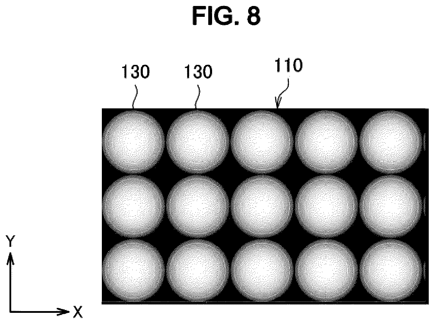

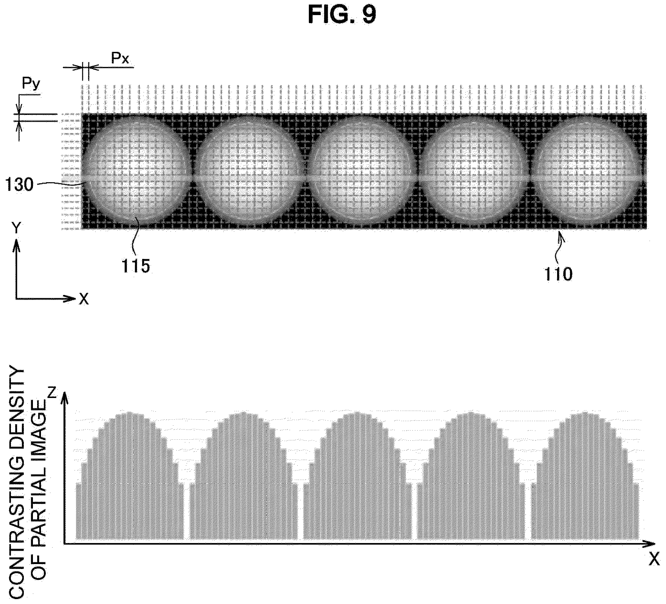

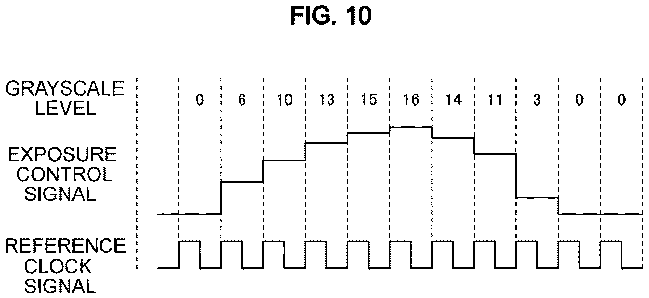

Next, another specific example of the method for generating the exposure control signal based on the input image 110 will be described in more detail with reference to FIGS. 8 to 10. Note that FIG. 8 is an explanatory diagram showing a specific example of the input image 110 according to the present embodiment. FIG. 9 is an explanatory diagram showing a specific example of the input image 110 divided into the plurality of small regions 115 and the contrasting density (the level of grayscale) of the partial image of the object 130. FIG. 10 is an explanatory diagram showing a specific example of the exposure control signal corresponding to a partial image of one of the objects 130 (microlenses) of the input image 110 shown in FIG. 9.

Note that also in the specific example of FIGS. 8 to 10, the input image 110 is divided into the plurality of small regions 115, and the exposure control signal is generated based on the contrasting density (the level of grayscale) of the partial image of each of the small regions 115, similarly to the above-mentioned specific example of FIGS. 6 and 7. Thus, detailed description of these division processing and generation processing will be omitted.

As shown in FIGS. 8 and 9, the input image 110 may be a grayscale image in which the plurality of objects 130 having the same shape are drawn. The input image 110 in the example of FIG. 8 represents a microlens array, and an individual microlens is equivalent to the object 130. As shown in FIG. 8, a plurality of microlenses are regularly arrayed as the objects 130 vertically and laterally (in the X and Y directions) in a square lattice shape. The plurality of microlenses are arranged at intervals from one another. The microlens (the object 130) in the example of FIG. 8 is a convex lens having a spherical or an aspherical shape, and a surface shape of the microlens has a three-dimensional shape which is higher toward the lens vertex. Thus, as shown in FIG. 9, in a region of the input image 110 where the microlens is present, the contrasting density of the image of the microlens is closer to white toward the lens vertex, and the level of grayscale increases (for example, the level = "1" to "16"). On the other hand, a non-lens region between the plurality of microlenses adj acent to one another is a flat surface having a low height, where the contrasting density of the image of the non-lens region is close to black, and the level of grayscale is at minimum (for example, the level = "0").

The input image 110 shown at the upper side in FIG. 9 is obtained by cutting a partial image of five microlenses (the objects 130) arrayed in the central row in the Y direction out of the input image 110 in FIG. 8. As shown in FIG. 9, the input image 110 is divided into the plurality of small regions 115 by square lattice-shaped grid lines. In the example of FIG. 9, the interval Px between the grid lines in the X direction and the interval Py between the grid lines in the Y direction are equal, and the small region 115 is a square grid. However, the present invention is not limited to such an example, and for example, the interval Px and the interval Py may be different from each other, and the small region 115 may be a grid having a rectangular shape or another shape.

As shown in FIG. 9, a region of the input image 110 in which one microlens (the object 130) is present preferably is divided into a large number of, for example, more than or equal to one hundred small regions 115 in accordance with the difference in height of the three-dimensional shape of the microlens (divided into ten or more small regions in the X direction and divided into ten or more small regions in the Y direction, for example). Accordingly, the three-dimensional spherical or aspherical shape of the individual microlens can be reproduced precisely and smoothly on the outer circumferential surface of the base member 11 of the master 1 using the partial image of the large number of small regions 115.

In addition, a bar graph shown at the lower side in FIG. 9 shows a change in the contrasting density (for example, the level of grayscale) of the partial image of one row that transverses five microlenses in the X direction substantially at the center in the Y direction in the input image 110 at the upper side in FIG. 9. As described, by dividing the input image 110 into the small regions 115 and then analyzing the partial image of each of the small regions 115, the contrasting density of the partial image of each of the small regions 115 is obtained. Accordingly, the change in height of the three-dimensional shape of the microlens two-dimensionally drawn in the input image 110 can be adequately recognized and reflected in the exposure control signal. Therefore, as shown in FIG. 10, the exposure control signal corresponding to the three-dimensional shape of the microlens can be generated from the contrasting density (the level of grayscale) of the partial image of each of the small regions 115.

The exposure control signal shown in FIG. 10 has a step-like waveform in accordance with the level of grayscale representing the contrasting density of the partial image of the microlens (the object 130) similarly to the exposure control signal in the above-mentioned example of FIG. 7. As the level of grayscale is higher, the signal level of the exposure control signal is set at a higher value. The change in the signal level of the exposure control signal corresponds to the change in height of the three-dimensional shape of one microlens. By exposing the resist layer 15 while modulating the intensity of the laser light 20 using the exposure control signal, the resist pattern 17 corresponding to the three-dimensional shape of the microlens array can be adequately reproduced on the resist layer 15.

The specific example of the input image 110 representing the microlens array in which a plurality of microlenses are regularly arrayed as the objects 130 and the exposure control signal generated based on the input image 110 has been described above with reference to FIGS. 8 to 10. According to this specific example, the master 1 for manufacturing the microlens array drawn in the input image 110 can be manufactured. According to the manufacturing method, the concave-convex structure 13 corresponding to the three-dimensional shape of the microlens array two-dimensionally drawn in the input image 110 shown in FIG. 8, for example, can be reproduced on the outer circumferential surface of the master 1 with high accuracy.

Note that the product targeted to be manufactured with the master 1 is not limited to the example of the microlens array shown in FIG. 8 and the like described above, and the present invention can be applied to various products. For example, the product targeted to be manufactured with the master 1 may be a microlens array in which a plurality of microlenses are irregularly arranged or may be an antireflection film, a diffuser panel, a polarizer, a diffraction grating, other various optical members, or the like on which a moth-eye structure having a concave-convex period of less than or equal to a wavelength belonging to a visible light band has been formed. The input image 110 in which a desired concave-convex structure formed on these various optical members is drawn as the object 130 in grayscale may be generated, and the input image 110 may be applied to the method for manufacturing the master 1 according to the present embodiment. Accordingly, the master 1 to be used for manufacturing products of an optical member having the desired concave-convex structure can be manufactured easily with high accuracy.

### [2.6. Configuration example of exposure device]

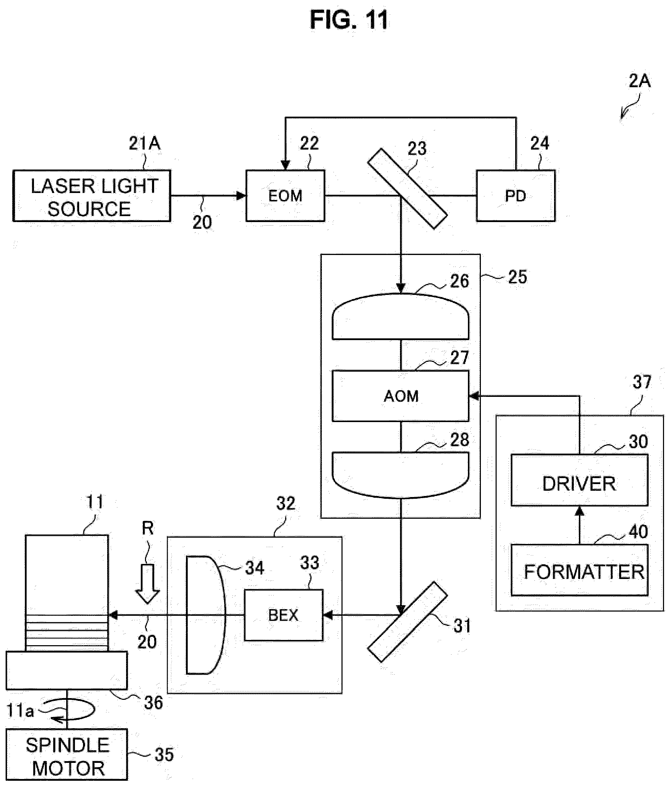

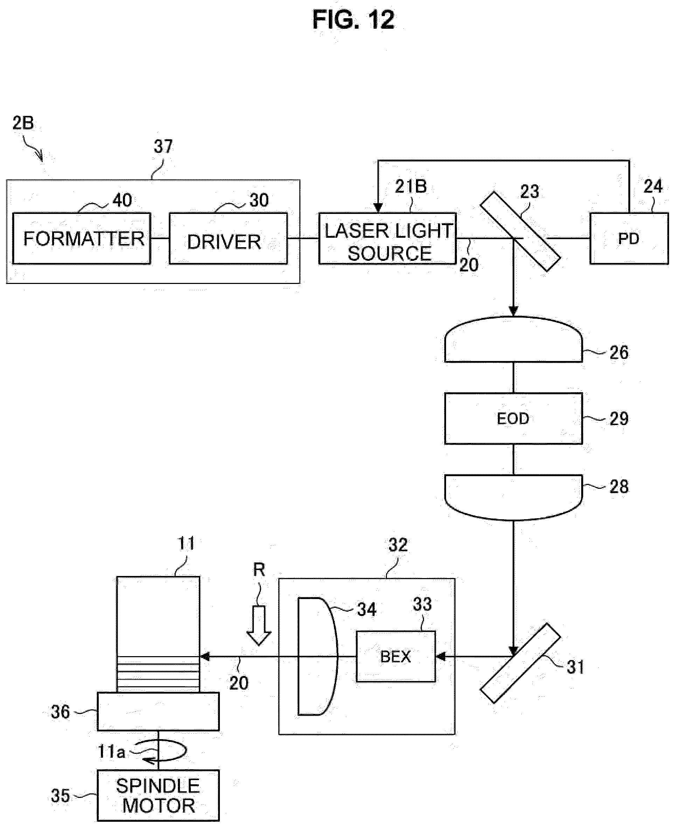

Next, a configuration example of the exposure device 2 to be used for the method for manufacturing the master 1 according to the present embodiment will be described with reference to FIGS. 11 and 12. FIG. 11 is an explanatory diagram showing a configuration example of an exposure device 2A according to the present embodiment. FIG. 12 is an explanatory diagram showing another configuration example of an exposure device 2B according to the present embodiment.

First, the exposure device 2A according to the present embodiment will be described with reference to FIG. 11. The exposure device 2A is an exposure device that uses a solid-state laser as a laser light source 21A.

As shown in FIG. 11, the exposure device 2A includes the laser light source 21A, an electro optical modulator (EOM) 22, a first mirror 23, a photodiode (PD) 24, a modulation optical system 25, a control mechanism 37, a second mirror 31, a moving optical table 32, the spindle motor 35, and a turntable 36. In addition, the base member 11 is placed on the turntable 36 and is capable of rotating.

The laser light source 21A is specifically a solid-state laser. For example, a solid-state laser or the like having a wavelength of 266 nm can be used as the laser light source 21A.

The laser light 20 exited from the laser light source 21A travels straight as a parallel beam and enters the electro optical modulator 22. The laser light 20 transmitted through the electro optical modulator 22 is reflected off the first mirror 23 and guided to the modulation optical system 25.

The first mirror 23 is composed of a polarization beam splitter and has a function of reflecting one of polarization elements and transmitting the other of the polarization elements. The polarization element transmitted through the first mirror 23 is received by the photodiode 24 and subjected to photoelectric conversion. In addition, a light reception signal obtained by the photoelectric conversion by the photodiode 24 is input to the electro optical modulator 22. The electro optical modulator 22 performs phase modulation of the laser light 20 based on the input light reception signal.

In addition, the modulation optical system 25 includes a condenser lens 26, an acousto-optic modulator (AOM) 27, and a collimator lens 28.

In the modulation optical system 25, the laser light 20 is condensed onto the acousto-optic modulator 27 formed from glass (SiO₂) and the like by the condenser lens 26. The laser light 20 is modulated in intensity by the acousto-optic modulator 27 and diffuses, and is then rendered into a parallel beam again by the collimator lens 28. The laser light 20 exited from the modulation optical system 25 is reflected off the second mirror 31 and guided onto the moving optical table 32 horizontally and in parallel.

In addition, the control mechanism 37 includes the formatter 40 and the driver 30 and controls radiation of the laser light 20. The formatter 40 generates the exposure control signal for controlling radiation of the laser light 20 as mentioned above, and the driver 30 controls the acousto-optic modulator 27 based on the exposure control signal generated by the formatter 40. Accordingly, radiation of the laser light 20 to the resist layer 15 is controlled.

The moving optical table 32 includes a beam expander (BEX) 33 and an objective lens 34. The laser light 20 guided to the moving optical table 32 is shaped into a desired beam shape by the beam expander 33 and then radiated to the resist layer 15 on the outer circumferential surface of the base member 11 through the objective lens 34.

Note that although not shown, the exposure device 2A preferably is subjected to focus control dynamically such that the laser light 20 is always focused on the resist layer 15 on the base member 11. Specifically, as for the base member 11, the distance from the objective lens 34 to the base member 11 varies during rotation due to axis offset of the rotation axis, processing accuracy of the surface of the base member 11, and the like. Thus, in order to always focus the laser light 20 on the resist layer 15 of the base member 11, the exposure device 2A preferably detects a focus shift of the laser light 20 and dynamically control focusing of the laser light 20. Note that as a method for detecting the focus shift of the laser light 20 with respect to the resist layer 15 on the base member 11, a method for detecting astigmatism of reflected light of the laser light 20 radiated to the resist layer 15, or the like can be used, for example.

With these components, the base member 11 is rotated by the turntable 36 at a constant speed and the laser light 20 is radiated while scanning the base member 11 in the axial direction at a constant speed, thereby exposing the resist layer 15. Note that scanning with the laser light 20 is performed by moving the laser light 20 by the moving optical table 32 in the direction of an arrow R at a constant speed.

Note that as described above, in the exposure device 2A, the rotation control signal for controlling rotation of the spindle motor 35 and the exposure control signal for controlling radiation of the laser light 20 are in synchronization such that actual radiated positions of the laser light 20 and radiated positions indicated by the exposure control signal conform (synchronize). Accordingly, the exposure device 2A can expose the resist layer 15 without the radiated position of the laser light 20 being shifted per rotation of the base member 11.

In addition, the rotating speed of the turntable 36 of the exposure device 2A and the frequency of the exposure control signal generated by the formatter 40 are determined by the outer circumferential length of the cylindrical shape of the base member 11 and the division interval Px in the circumferential direction (the X direction) of the input image 110. Furthermore, a feed pitch of the moving optical table 32 of the exposure device 2A is determined by the division interval Py in the axial direction (the Y direction) of the input image 110. In other words, these exposure parameters are determined such that the radiated positions of the laser light 20 conform to the divided small regions of the input image 110.

Next, an exposure device 2B according to another configuration example of the present embodiment will be described with reference to FIG. 12. The exposure device 2B is an exposure device that uses a semiconductor laser as a laser light source 21B.

As shown in FIG. 12, the exposure device 2B includes the laser light source 21B, the first mirror 23, the photodiode (PD) 24, the condenser lens 26, an electro optic deflector (EOD) 29, the collimator lens 28, the control mechanism 37, the second mirror 31, the moving optical table 32, the spindle motor 35, and the turntable 36. In addition, the base member 11 is placed on the turntable 36 and is capable of rotating.

Herein, since the moving optical table 32, the spindle motor 35, and the turntable 36 are similar to those of the exposure device 2A described with reference to FIG. 11, description thereof will be omitted here.

The laser light source 21B specifically is a semiconductor laser. For example, a blue semiconductor laser that emits laser light having a wavelength in the blue light band of 400 nm to 500 nm can be used as the laser light source 21B. In the exposure device used in the manufacturing method according to the present embodiment, a semiconductor laser preferably is used as the laser light source 21B.

The laser light 20 exited from the laser light source 21B travels straight as a parallel beam and is reflected off the first mirror 23. In addition, the laser light 20 reflected off the first mirror 23 is condensed onto the electro optic deflector 29 by the condenser lens 26, and is then rendered into a parallel beam again by the collimator lens 28. The laser light 20 rendered into the parallel beam is reflected off the second mirror 31 and guided onto the moving optical table 32 horizontally and in parallel.

The first mirror 23 is composed of a polarization beam splitter and has a function of reflecting one of polarization elements and transmitting the other of the polarization elements. The polarization element transmitted through the first mirror 23 is received by the photodiode 24 and subjected to photoelectric conversion. In addition, a light reception signal obtained by the photoelectric conversion by the photodiode 24 is input to the laser light source 21B. The laser light source 21B modulates the laser light 20 based on the input light reception signal.

The electro optic deflector 29 is an element capable of controlling radiated positions of the laser light 20. The exposure device 2B is also capable of changing the radiated positions of the laser light 20 to be guided onto the moving optical table 32 by the electro optic deflector 29.

In addition, the control mechanism 37 includes the formatter 40 and the driver 30 and controls radiation of the laser light 20. The driver 30 controls output of the laser light source 21B based on the exposure control signal generated by the formatter 40. Accordingly, radiation of the laser light 20 to the resist layer 15 is controlled.

Note that the exposure device 2B shown in FIG. 12 dynamically controls focus of the laser light 20 and brings the rotation control signal for the spindle motor 35 and the exposure control signal for the laser light 20 into synchronization, similarly to the exposure device 2A shown in FIG. 11.

### [3. Conclusion]

The method for manufacturing the master 1 according to the present embodiment, the manufacturing apparatus for the master 1 to be used for the manufacturing method, the manufacturing methods for the transferred object and the replica master, and the like have been described above in detail. According to the present embodiment, the intensity of the laser light 20 is modulated in accordance with the contrasting density (for example, the level of grayscale) of the image of the object 130 drawn in any input image 110, and the resist layer 15 on the outer circumferential surface of the base member 11 is exposed using the laser light 20 modulated in intensity. By this exposure method, the resist pattern 17 corresponding to any three-dimensional shape of the object 130 can be formed on the resist layer 15. Therefore, by performing steps such as etching of the outer circumferential surface of the base member 11 using the resist pattern 17, the concave-convex structure 13 corresponding to the three-dimensional shape can be formed on the outer circumferential surface of the base member 11. Thus, according to the present embodiment, a pattern of the concave-convex structure 13 corresponding to the object 130 having any three-dimensional shape can be formed on the outer circumferential surface of the base member 11 of the master 1 at a higher accuracy than in the conventional art.

In more detail, in the technology disclosed in the above-described Patent Literature 1, exposure is performed for each of sectioned exposure target regions. The exposure target regions are sectioned by boundary portions between concavities in which an intensity of exposure light is small and an exposure depth is shallow. This raises the problem in that a concave-convex structure having any three-dimensional shape in which concave-convex structures of adjacent sections are coupled continuously and seamlessly cannot be freely formed.

In contrast, according to the present embodiment, the grid lines for dividing the input image 110 into the plurality of small regions 115 can be freely set regardless of the arrangement and the concave-convex shape of the objects 130 in the input image 110. Since the flexibility of the method for dividing the input image 110 into the small regions 115 is high as described, the exposure control signal flexibly corresponding to the arrangement and the concave-convex shape of the object 130 can be generated and utilized for exposure of the resist layer 15. Thus, the concave-convex structure 13 corresponding to the object 130 having any three-dimensional shape can be freely formed on the outer circumferential surface of the master 1.

In addition, the technology described in the above-described Patent Literature 1 performs scanning exposure of relatively moving exposure light in the planar direction of the resist film for continuous radiation rather than intermittently radiating a spot of laser light modulated in intensity in accordance with the input image 110 as exposure light. Thus, such continuous scanning exposure raises a problem in that it is difficult to form a pattern of a concave-convex structure having a desired three-dimensional shape with high accuracy.

In contrast, according to the present embodiment, a spot of the laser light 20 modulated in intensity in accordance with the contrasting density of the input image 110 is used as exposure light, and the spot of the laser light 20 is radiated intermittently or continuously to each of regions of the resist layer 15 corresponding to the small regions 115 of the input image 110. On this occasion, the spot of the laser light 20 modulated in intensity is radiated to each of the regions of the resist layer 15 corresponding to the small regions 115 while modulating the intensity of the laser light 20 for each of the small regions 115 of the input image 110. Herein, the size (such as, for example, the area or the intervals Px, Pc) of the small regions 115 preferably is smaller than the size (such as, for example, the radiated area or spot diameter) of the spot of the laser light 20 to be radiated to the resist layer 15. By this gradation exposure method, the resist layer 15 can be suitably exposed to a desired depth, into a desired three-dimensional shape, and in a desired arrangement in conformity to the height, three-dimensional shape, and arrangement of the objects 130 drawn in the input image 110. Therefore, the resist pattern 17 composed of the plurality of latent images 16 corresponding to the objects 130 can be formed with high accuracy and freely. Thus, the pattern of the concave-convex structure 13 having a desired three-dimensional shape can be formed with high accuracy and freely on the outer circumferential surface of the base member 11 of the master 1 using the resist pattern 17.

In addition, in the technology described in Patent Literature 2 above, the intensity of laser light is not modulated when the resist layer on the outer circumferential surface of the roll master is exposed, and the concave-convex pattern is exposed by turning on/off laser light having a constant intensity. Therefore, the depth of the pattern of the concave-convex structure cannot be changed arbitrarily, which raises the problem in that it is difficult to freely form a concave-convex structure having any three-dimensional shape.

In contrast, according to the present embodiment, the intensity of the laser light 20 to be radiated to the resist layer 15 can be freely modulated in conformity to the contrasting density (for example, the level of grayscale) of the partial image of the object 130 in the input image 110. Therefore, the resist pattern 17 having a desired three-dimensional shape can be formed appropriately when the resist layer 15 is exposed. Thus, the depth, three-dimensional shape, and arrangement of the micro concave-convex structure 13 formed on the outer circumferential surface of the master 1 using the resist pattern 17 can be freely changed in conformity to the pattern of the three-dimensional shape of the desired object 130.

Furthermore, the master 1 manufactured by the manufacturing method according to the present embodiment is a roll master having a cylindrical shape or a columnar shape and has the concave-convex structure 13 having any three-dimensional shape formed on its outer circumferential surface. Herein, the three-dimensional shape of the concave-convex structure 13 may be various shapes corresponding to any object 130 as shown in FIGS. 1 and 6, for example, or may be a concave-convex shape of an optical member such as a microlens array in which a plurality of microlenses (an individual microlens of which is an example of the object 130) are arrayed regularly or irregularly as shown in FIGS. 8 and 9.

By manufacturing the transferred object using this roll master 1, the productivity and quality of the transferred object (for example, an optical sheet on which a microlens array has been formed) having a surface to which the concave-convex structure 13 having any three-dimensional shape as described above has been transferred can be improved. Furthermore, in the present embodiment, the transferred object is manufactured in the roll-to-roll system using the manufacturing apparatus including the roll master 1. Accordingly, a product including a micro concave-convex structure such as a microlens array can be manufactured more inexpensively and with higher productivity than conventional manufacturing apparatuses including a planar master.

### [Examples]

Examples of the method for manufacturing the master according to the present embodiment mentioned above will be specifically described below. Note that the following examples are examples for presenting the practicability and effects of the method for manufacturing the master according to the above-described embodiment, and the method for manufacturing the master according to the present invention is not limited to the following examples.

The masters 1 and the transferred objects according to Examples 1 to 4 of the present invention were manufactured by the following manufacturing methods.

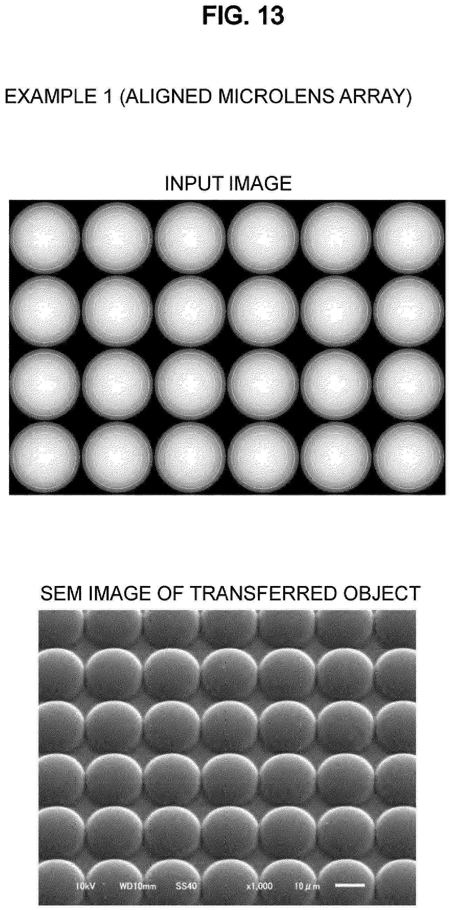

### (Example 1: FIG. 13)

First, a method for manufacturing the master 1 and the transferred object according to Example 1 will be described.

In the resist deposition step (S10), the resist layer 15 having a thickness of 10 µm was formed on the outer circumferential surface of the cylindrical base member 11 by a dip coating method. As the base member 11, a base member made of cylindrical quartz glass having a thickness of 4.5 mm was used. As the resist material, a positive-type photoresist (for example, the product name: "AZ-P4210" made by Merck & Co., Inc.) as an organic resist was used.

Then, in the exposure control signal generation step (S20), the exposure control signal was generated using the input image 110. As the input image 110 (an exposure pattern), a grayscale image of a microlens array in which a plurality of microlenses (equivalent to the objects 130) having the same shape were arrayed regularly in a square lattice shape was used as shown in FIG. 13. In this microlens array, the microlenses having a diameter of 20 µm and a height of 4 µm were aligned at a pitch of 20 µm substantially without gaps between one another. The intervals Px, Py (see FIG. 9) at which the input image 110 was divided into the plurality of small regions 115 was set at 200 nm. The levels of grayscale indicating the contrasting density of the partial image of the microlenses were set at 256 levels.

Thereafter, in the exposure step (S30), the resist layer 15 deposited on the outer circumferential surface of the base member 11 was exposed while modulating the intensity of the laser light 20 based on the exposure control signal. Specifically, the latent image 16 was formed on the resist layer 15 of the base member 11 using the exposure device 2B shown in FIG. 12 through photolithography with the laser light 20. A blue semiconductor laser that emits the laser light 20 having a wavelength of 405 nm was used as the laser light source 21B of the exposure device 2B. In addition, the base member 11 was scanned with the laser light 20 in the axial direction of the base member 11 at 1.5 µm/sec at the time of exposure while rotating the base member 11 around the central axis 11a at 900 rpm.

Then, in the development step (S40), the base member 11 after the above-described exposure was developed. In this development step, the base member 11 was developed at 27°C for 1800 seconds using a 2.38 mass % aqueous solution of TMAH to dissolve resist in an exposed portion, thereby forming the resist pattern 17.

Thereafter, in the etching step (S50), the base member 11 was dry-etched using the resist pattern 17 after the above-described development as a mask. In this etching step, reactive ion etching was performed using a CHF₃ gas (flow rate: 30 sccm) as an etching gas at a gas pressure of 0.5 Pa in a chamber, at applied RF power of 150W for an etching time of 300 minutes. By this etching step, the concave-convex structure 13 was formed on the outer circumferential surface of the base member 11.

The master 1 according to Example 1 was manufactured through the above steps. Furthermore, the transferred object according to Example 1 was manufactured using the manufactured master 1. Specifically, the resin layer 62 made of an ultraviolet curing resin was laminated on a surface of a sheet-like base member (the to-be-transferred object 61) of the transferred object using the transfer device 6 as shown in FIG. 2, and the concave-convex structure 13 formed on the outer circumferential surface of the master 1 was transferred to the resin layer 62 yet to be cured. Note that a polyethylene terephthalate (PET) film was used for the sheet-like base member of the transferred object. Thereafter, ultraviolet rays of 1000 mJ/cm² were radiated for one minute with a metal halide lamp to cure the resin layer 62 made of the ultraviolet curing resin. As described above, the transferred object (a product of the microlens array) in which the concave-convex structure 13 of the master 1 has been transferred to the resin layer 62 was manufactured.

An SEM image of the aligned microlens array which is the transferred object according to Example 1 manufactured as described above is shown at the lower side of FIG. 13. As shown in FIG. 13, it is found that in the aligned microlens array according to Example 1, the three-dimensional shape of the microlens array composed of the plurality of microlenses (the objects 130) drawn in the input image 110 has been reproduced with high accuracy on a surface of the transferred object.

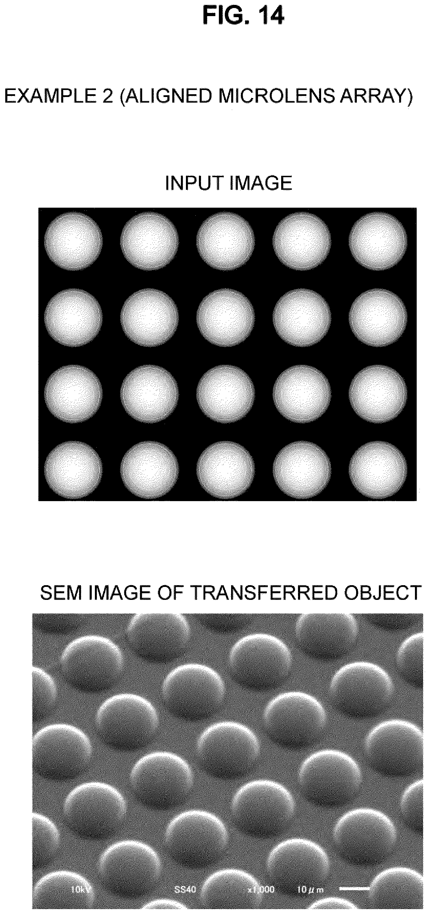

### (Example 2: FIG. 14)

Next, the method for manufacturing the master 1 and the transferred object according to Example 2 will be described. In Example 2, the master 1 and the transferred object were manufactured by a manufacturing method similar to that of Example 1 except for the input image 110 to be used in the exposure control signal generation step (S20).

In Example 2 (FIG. 14), the input image 110 for manufacturing an aligned microlens array in which microlenses were arrayed at an array pitch larger than in Example 1 (FIG. 13) was used. As the input image 110 according to Example 2, a grayscale image of a microlens array in which a plurality of microlenses (equivalent to the objects 130) having the same shape were arrayed regularly in a square lattice shape was used as shown in FIG. 14. In this microlens array, the microlenses having a diameter of 25 µm and a height of 3 µm were aligned at a pitch of 25 µm at intervals from one another. The intervals Px, Py (see FIG. 9) at which the input image 110 was divided into the plurality of small regions 115 were set at 200 nm. The levels of grayscale indicating the contrasting density of the partial image of the microlenses were set at 256 levels.

An SEM image of the aligned microlens array as the transferred object according to Example 2 is shown at the lower side of FIG. 14. As shown in FIG. 14, it is found that, also in the aligned microlens array according to Example 2, the three-dimensional shape of the microlens array composed of the plurality of microlenses (the objects 130) drawn in the input image 110 has been reproduced on a surface of the transferred object with high accuracy.

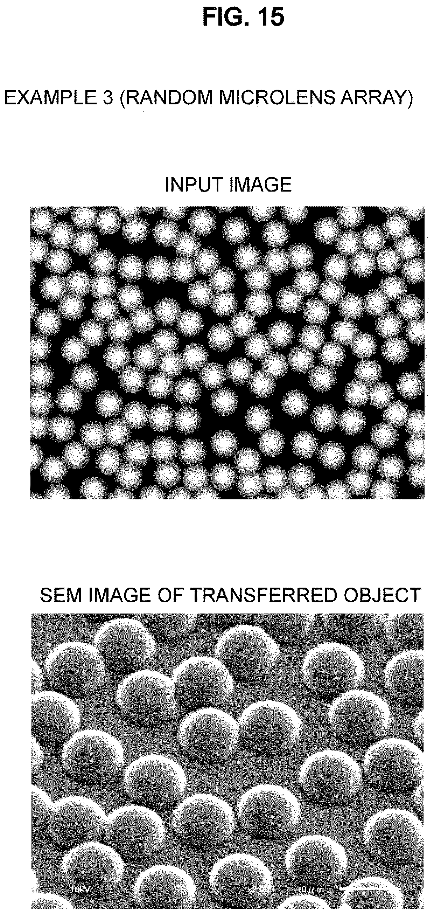

### (Example 3: FIG. 15)

Next, the method for manufacturing the master 1 and the transferred object according to Example 3 will be described. In Example 3, the master 1 and the transferred object were manufactured by a manufacturing method similar to that of Example 1 except for the input image 110 to be used in the exposure control signal generation step (S20).

In Example 3 (FIG. 15), the input image 110 for manufacturing a random microlens array in which a plurality of microlenses were irregularly arranged was used. As the input image 110 according to Example 3, a grayscale image of a microlens array in which a plurality of microlenses (equivalent to the objects 130) having substantially the same shape were arranged at random was used as shown in FIG. 15. In this microlens array, the microlenses generally having a diameter of 10 µm and a height of 3 µm were arranged at random dispersedly to some degree. The intervals Px, Py (see FIG. 9) at which the input image 110 was divided into the plurality of small regions 115 were set at 200 nm. The levels of grayscale indicating the contrasting density of the partial image of the microlenses were set at 256 levels.

An SEM image of the random microlens array as the transferred object according to Example 3 is shown at the lower side of FIG. 15. As shown in FIG. 15, it is found that in the random microlens array according to Example 3, the three-dimensional shape of the microlens array composed of the plurality of microlenses (the objects 130) drawn in the input image 110 has been reproduced on a surface of the transferred object with high accuracy.

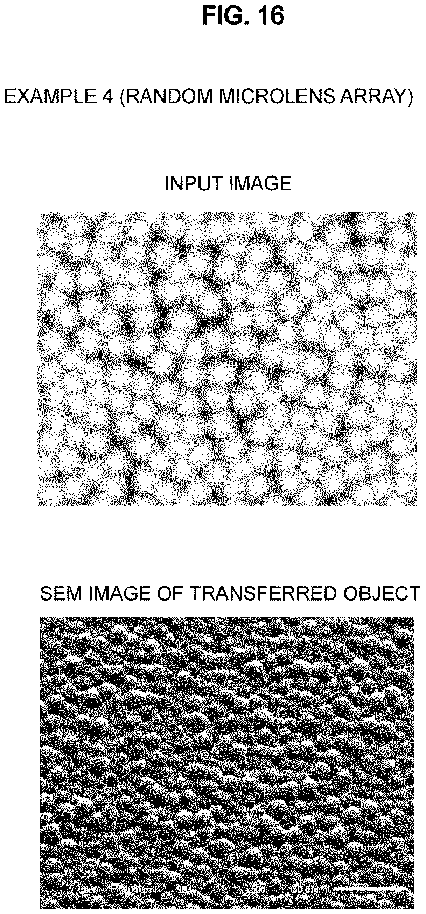

### (Example 4: FIG. 16)

Next, the method for manufacturing the master 1 and the transferred object according to Example 4 will be described. In Example 4, the master 1 and the transferred object were manufactured by a manufacturing method similar to that of Example 1 except for the input image 110 to be used in the exposure control signal generation step (S20).

In Example 4 (FIG. 16), the input image 110 for manufacturing a random microlens array in which a larger number of microlenses were arranged densely and irregularly than in Example 3 (FIG. 15) was used. As the input image 110 according to Example 4, a grayscale image of a microlens array in which a plurality of microlenses (equivalent to the objects 130) having shapes different from each other were arranged at random as shown in FIG. 16 was used. In this microlens array, the microlenses generally having a diameter of 10 µm and a height of 2 µm were arranged densely without gaps between one another and at random. The intervals Px, Py (see FIG. 9) at which the input image 110 was divided into the plurality of small regions 115 were set at 200 nm. The levels of the grayscale image indicating the contrasting density of the partial image of the microlenses were set at 256 levels.

An SEM image of the random microlens array as the transferred object according to Example 4 is shown at the lower side of FIG. 16. As shown in FIG. 16, it is found that, also in the random microlens array according to Example 4, the three-dimensional shape of the microlens array composed of the plurality of microlenses (the objects 130) drawn in the input image 110 has been reproduced on a surface of the transferred object with high accuracy.

The foregoing results of Examples 1 to 4 confirmed that the pattern of the micro concave-convex structure 13 of the microlens array having any three-dimensional shape was able to be formed with high accuracy on the outer circumferential surface of the master 1 by the method for manufacturing the master according to the present embodiment. It was also confirmed that the concave-convex structure 13 of the master 1 was able to be transferred to the transferred object with high accuracy by the method for manufacturing the transferred object through use of the master 1, enabling products of various microlens arrays to be mass-produced inexpensively and efficiently.

The preferred embodiment(s) of the present invention has/have been described above in detail with reference to the accompanying drawings, whilst the present invention is not limited to the above examples. A person skilled in the art may find various alterations and modifications within the scope of the technical idea described in the appended claims, and it should be understood that they will naturally come under the technical scope of the present invention.

Note that the master 1 and the transferred object thereof manufactured by the manufacturing method according to the present embodiment can suitably achieve a concave-convex structure having any three-dimensional shape and thus can be applied to various applications.

For example, the transferred object can be applied to the printed electronics by forming a circuit on the transferred concave-convex structure. As another example, the transferred object can be applied to a biosensor or diagnostic device by forming a flow passage of a biological sample such as the blood in the transferred concave-convex structure. The transferred object can also be applied to an optical element by controlling optical characteristics by the transferred concave-convex structure. Moreover, the transferred object can be applied to a particle array sheet by using the transferred concave-convex structure.

### Reference Signs List

1 master
2, 2A, 2B exposure device
6 transfer device
11 base member
12, 12A, 12B, 12C concavity
13 concave-convex structure
15 resist layer
16 latent image
17 resist pattern
18 concavity
20 laser light
21 laser light source
30 driver (laser modulation driver)
40 formatter (exposure control device)
110 input image
115 small region
401 input image acquisition unit
403 small-region division unit
405 signal generation unit
407 clock signal generation unit

## Claims

1. A method for manufacturing a master, comprising the steps of:
forming a resist layer on an outer circumferential surface of a base member having a cylindrical shape or a columnar shape;
dividing an input image in which at least one object having a three-dimensional shape is two-dimensionally drawn into a plurality of small regions;
determining whether or not to radiate laser light to each of the small regions based on whether or not the object is included in each of the small regions, determining in a stepwise manner an intensity of the laser light to be radiated to each of the small regions based on a contrasting density of a partial image of the object in each of the small regions in which the object is included, and generating an exposure control signal corresponding to the object based on a result of the determining of the intensity of the laser light;
radiating, to the resist layer, the laser light modulated in the intensity in accordance with the contrasting density of the partial image of the object for each of the small regions based on the exposure control signal, thereby forming a resist pattern corresponding to the object on the resist layer; and
forming a concave-convex pattern corresponding to the three-dimensional shape of the object on the outer circumferential surface of the base member using, as a mask, the resist layer on which the resist pattern has been formed, wherein
in the resist pattern, the resist pattern changes in depth in each of the small regions in accordance with the contrasting density of the partial image of the object.

2. The method for manufacturing the master according to claim 1, wherein
the input image is a grayscale image that expresses a change in height of the three-dimensional shape of the object using the contrasting density of the grayscale image, and
in the step of generating the exposure control signal, the intensity of the laser light to be radiated to each of the small regions is determined in a stepwise manner based on a level of a grayscale of the partial image of the object in each of the small regions in which the object is included.

3. The method for manufacturing the master according to claim 1 or 2, wherein the exposure control signal is a modulation signal for modulating in a stepwise manner the intensity of the laser light that exposes the resist layer and has a step-like waveform in accordance with a level of a grayscale that represents the contrasting density of the partial image of the object.

4. The method for manufacturing the master according to any one of claims 1 to 3, wherein the small regions each have a size smaller than a size of a spot of the laser light.

5. The method for manufacturing the master according to any one of claims 1 to 4, wherein in the step of forming the resist pattern on the resist layer, the laser light is radiated to the resist layer of the base member while the base member is rotated using a central axis of the base member as a rotation axis.

6. The method for manufacturing the master according to claim 5, wherein the exposure control signal is generated so as to be synchronized with a signal for controlling rotation of the base member.

7. The method for manufacturing the master according to any one of claims 1 to 6, wherein
a light source of the laser light is a semiconductor laser,
the resist layer is made of an organic resist, and
in the step of forming the resist pattern on the resist layer, the resist pattern is formed on the resist layer through photolithography.

8. A method for manufacturing a transferred object, comprising the step of transferring a pattern of the master manufactured by the manufacturing method according to any one of claims 1 to 7.

9. A method for manufacturing a replica master, comprising the step of transferring a pattern of the transferred object manufactured by the manufacturing method according to claim 8.

10. A method for manufacturing a transferred object, comprising the step of transferring a pattern of the replica master manufactured by the manufacturing method according to claim 9.

11. An apparatus for manufacturing a master, comprising:
a deposition device that forms a resist layer on an outer circumferential surface of a base member having a cylindrical shape or a columnar shape;
an exposure control device that divides an input image in which at least one object having a three-dimensional shape is two-dimensionally drawn into a plurality of small regions, makes a determination as to whether or not to radiate laser light to each of the small regions based on whether or not the object is included in each of the small regions, makes a determination in a stepwise manner as to an intensity of the laser light to be radiated to each of the small regions based on a contrasting density of a partial image of the object in each of the small regions in which the object is included, and generates an exposure control signal corresponding to the object based on a result of the determination of the intensity of the laser light;
an exposure device that radiates, to the resist layer, the laser light modulated in the intensity in accordance with the contrasting density of the partial image of the object for each of the small regions based on the exposure control signal, thereby forming a resist pattern corresponding to the object on the resist layer; and
an etching device that forms a concave-convex pattern corresponding to the three-dimensional shape of the object on the outer circumferential surface of the base member using, as a mask, the resist layer on which the resist pattern has been formed, wherein
in the resist pattern, the resist pattern changes in depth in each of the small regions in accordance with the contrasting density of the partial image of the object.
